# EUROPEAN PATENT APPLICATION

(11) **EP 2 453 469 A1**
(43) Date of publication of application: **16.05.2012**
(21) Application number: 10796970.1
(22) Date of filing: 31.05.2010
(51) Int. Cl.: H01L 21/301, C09J 7/02, C09J 133/00, C09J 161/06, C09J 163/00, H01L 21/52

(54) **FILM FOR SEMICONDUCTOR AND SEMICONDUCTOR DEVICE MANUFACTURING METHOD**

(30) Priority: 09.07.2009 JP 2009163036
(71) Applicant: Sumitomo Bakelite Company Limited, Shinagawa-ku Tokyo 140-0002 (JP)
(72) Inventor: YASUDA Hiroyuki, Tokyo 140-0002 (JP); HIRANO Takashi, Tokyo 140-0002 (JP)
(74) Representative: Solf, Alexander
(86) International application number: PCT/JP2010/059190
(87) International publication number: WO 2011/004659

(57) **Abstract**

A film for semiconductor includes a support film, a second adhesive layer, a first adhesive layer and a bonding layer which are laminated together in this order. This film for semiconductor is configured so that it supports a semiconductor wafer laminated on the bonding layer thereof when the semiconductor wafer is diced and the bonding layer is selectively peeled off from the first adhesive layer when a chip is picked up. This film for semiconductor is **characterized in that** in the case where peel strength at 23°C of the chip is defined as "F₂₃ (cN/25mm)" and peel strength at 60°C of the chip is defined as "F₆₀ (cN/25mm) ", F₂₃ is in the range of 10 to 80 and F₆₀/F₂₃ is in the range of 0.3 to 5.5. This makes it possible to improve a pickup property of the chip, to thereby prevent generation of defects in a semiconductor element.

## Description

### TECHNICAL FIELD

The present invention relates to a film for semiconductor and a semiconductor device manufacturing method (that is, a method for manufacturing a semiconductor device).

### BACKGROUND ART

According to the recent trend of high functionality of electronic devices and expansion of their use to mobile applications, there is an increasing demand for developing a semiconductor device having high density and high integration. As a result, an IC package having high capacity and high density is developed.

In a method for manufacturing the semiconductor device, a bonding sheet is, first, attached to a semiconductor wafer made of silicon, gallium, arsenic or the like, and then the semiconductor wafer is fixed using a wafer ring at a peripheral portion thereof and is diced (or segmented) into individual semiconductor elements during a dicing step.
Next, an expanding step in which the semiconductor elements obtained by the dicing are separated from each other and a pickup step in which the separated semiconductor elements are picked up are carried out. Thereafter, the picked up Semiconductor elements are transferred into a die bonding step in which each picked up semiconductor elements is mounted onto a metal lead frame or a substrate (e.g., a tape substrate, an organic hard substrate). In this way, the semiconductor device can be obtained.

Further, by laminating the picked up semiconductor element onto another semiconductor element during the die bonding step, it is also possible to obtain a chip stack-type semiconductor device including a plurality of semiconductor elements in one package.

As the bonding sheet which can be used in such a method for manufacturing a Semiconductor device, a bonding sheet in which a first adhesive bonding layer and a second adhesive bonding layer are laminated together in this order onto a base film is known (for example. Patent Document 1).

As described above, this bonding sheet is attached to a semiconductor wafer in the above dicing step. During the dicing step, cutting lines are formed so that an edge of a dicing blade comes down to the base film, to thereby dice the semiconductor wafer and the two adhesive bonding layers into a plurality of parts.
Thereafter, during the pickup step, the two adhesive bonding layers are peeled off from the base film at an interface therebetween, to thereby pick up a semiconductor element (that is, the diced semiconductor wafer) together with the diced two adhesive bonding layers. The picked up two adhesive bonding layers are used for bonding the semiconductor element obtained by the dicing to a metal lead frame (or a substrate) during the die bonding step.

Meanwhile, equipment referred to as a die bonder is used during the pickup step.

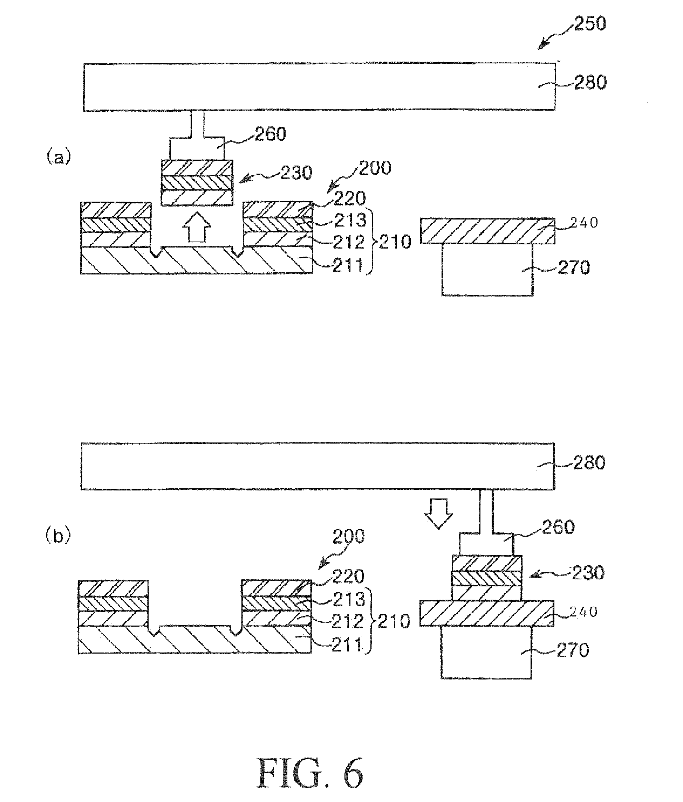

FIG. 6 is a view (sectional view) showing an appearance in which a semiconductor element is picked up using the die bonder, and then mounted onto a substrate. In this regard, in the following description, the upper side in each of FIG. 6 will be referred to as "upper" and the lower side thereof will be referred to as "lower".

A laminated body 200 shown in FIG. 6 includes a bonding sheet 210 in which a base film 211, a first adhesive bonding layer 212 and a second adhesive bonding layer 213 are laminated together in this order from a lower side thereof, and a semiconductor wafer 220 laminated on the bonding sheet 210. When the dicing step is carried out on this laminated body 200, the semiconductor wafer 220, the first adhesive bonding layer 212 and the second adhesive bonding layer 213 are diced, to thereby obtain chips 230. Each chip 230 comprises a diced semiconductor wafer (semiconductor element) and diced adhesive bonding layers).

Here, a die bonder 250 shown in FIG. 6 picks up the chips 230 obtained through the dicing step, and transfers them onto a substrate 240.

This die bonder 250 includes a collect (chip absorption section) 260 for absorbing the chip 230, a heater 270 for heating the substrate 240 from a slower side thereof, an equipment main body 280 for holding the collet 260 so as to be freely moved. The collet 260 is configured so as to be transferred from a stage for mounting the laminated body 200 to a stage for mounting the substrate 240 in the state of absorbing the chip 230.

During the pickup step, the chip 230 is picked up by the collet 260, and then mounted onto the substrate 240. Thereafter, the chip 230 is pressed onto the substrate 240 while being heated by the heater 270 so that the chip 230 is bonded to the substrate 240.

However, there is a problem in that efficiency of picking up the chip 230 and a yield ratio thereof are inferior during the conventional pickup step. As a result, this causes lowering of productivity of semiconductor devices finally obtained.

### PRIOR ART DOCUMENT

### PATENT DOCUMENT

Patent Document 1: JP-A 2004-43761

### OUTLINE OF THE INVENTION

Further, by repeating the process, in which the chip 230 is picked up using the die bonder 250, and then pressed onto the substrate 240, heat from the heater 270 is transferred to the collet 260 through the chip 230, and accumulated thereto. In this way, since the collet 260 becomes hot, the pickup step is carried out at a high temperature in consequence of the heat, although this step is assumed to be carried out at a normal temperature under ordinary circumstances.
As a result, the heat from the collet 260 is also transferred to the laminated body 200, which causes increase of an adhesive bonding property of the first adhesive bonding layer 212 or the second adhesive bonding layer 213 included in the laminated body 200. In such a state, the chips 230, which have been once separated form each other through the dicing step, are re-bonded together or adhesive strength of an interface between the base film 211 and the two adhesive bonding layers, which are peeled off from each other during the pickup step, is enhanced.
This causes a problem in that smooth pickup of the chip 230 becomes difficult (that is, a pickup property of the chip 230 is lowered), to thereby generate defects such as breakage and crack in the semiconductor element when being picked up.

It is an object of the present invention to provide a film for semiconductor which can improve a pickup property and manufacture a semiconductor device having high reliability while preventing generation of defects in a semiconductor element, and a method for manufacturing a semiconductor device using such a film for semiconductor.

In order to achieve the object described above, the present invention is directed to a film for semiconductor comprising a bonding lawyer, at least one adhesive layer and a support film which are laminated together in this order, the film for semiconductor being adapted to be used for picking up chips obtained by laminating a semiconductor wafer onto a surface of the bonding layer opposite to the adhesive layer, and then dicing the semiconductor wafer together with the bonding layer in the laminated state into the chips,
wherein in the case where adhesive strength measured when the chip is peeled off from the adhesive layer at 23°C is defined as "F₂₃ (cN/25mm)" and adhesive strength measured when the chip is peeled off from the adhesive layer at 60°C is defined as "F₆₀ (cN/25mm)", F₂₃ is in the range of 10 to 80 and F₆₀/F₂₃ is in the range of 0.3 to 5.5.
According to such a present invention, the film for semiconductor is configured so that a ratio of peel strength at a high temperature (60°C) between the adhesive layer and the bonding layer to peel strength at a low temperature (23°C) between the adhesive layer and the bonding layer becomes a predetermined value. Therefore, even in the case where heat is transferred to the chip when being picked up, it is possible to prevent a pickup property of the chip from being lowered. Therefore, according to the present invention, it is possible to obtain a film for semiconductor which can improve a yield ratio of manufacturing semiconductor devices and to manufacture semiconductor devices each having high reliability,

Further, in the film for semiconductor according to the present invention, it is preferred that a constituent material of the bonding layer contains a thermosetting resin including a compound having a softening point of 70 to 130°C of which amount is in the range of 60 to 100 wt%.

Further, in the film for semiconductor according to the present invention, it is preferred that a constituent material of the bonding layer contains a thermosetting resin including a compound having a softening point of 30°C or more but less than 70°C of which amount is in the range of 30 wt% or less.

Further, in the film for semiconductor according to the present invention, it is preferred that a constituent material of the bonding layer contains a thermosetting resin including a compound having an ICI viscosity at 25°C of 1 to 20 dPa·s of which amount is in the range of 60 to 100 wt%.

Further, in the film for semiconductor according to the present invention, it is preferred that a melt viscosity at 60°C of a constituent material of the bonding layer is in the range of 1 × 10² to 1 × 10⁵ Pa·s.

Further, in the film for semiconductor according to the present invention, it is preferred that a constituent material of the bonding layer contains an acryl-based resin and an epoxy-based resin.

Further, in the film for semiconductor according to the present invention, it is preferred that a constituent material of the bonding layer contains a phenol-based resin.

Further, in the film for semiconductor according to the present invention, it is preferred that the at least one adhesive layer comprises a plurality of adhesive layers.

Further, in the film for semiconductor according to the present invention, it is referred that the plurality of adhesive layers include a first adhesive layer positioned at a side of the semiconductor wafer, and a second adhesive layer provided between the first adhesive layer and the support film, the second adhesive layer having an adhesive property larger than that of the first adhesive layer.

Further, in the film for semiconductor according to the present invention, it is preferred that a peripheral edge of the bonding layer and a peripheral edge of the first adhesive layer are located inside a peripheral edge of the second adhesive layer, respectively.

Further, in the film for semiconductor according to the present invention, it is preferred that hardness of the second adhesive layer is smaller than that of the first adhesive layer.

Further, in the film for semiconductor according to the present invention, it is preferred that Shore D hardness of the first adhesive layer is in the range of 20 to 60.

Further, in the film for semiconductor according to the present invention, it is preferred that a region of a surface of the adhesive layer facing the bonding layer, above which the semiconductor wafer is to be laminated, has been, in advance, irradiated with an ultraviolet ray before the semiconductor wafer is laminated onto the film for semiconductor.

In order to achieve the other object described above, the present invention is directed to a method for manufacturing a semiconductor device comprising:
a first step of laminating a semiconductor wafer onto the above film for semiconductor so that the semiconductor wafer makes contact with the bonding layer to obtain a laminated body;
a second step of dicing the semiconductor wafer into a plurality of semiconductor elements by forming cutting lines into the laminated body from a side of the semiconductor wafer; and
a third step of picking up the chips each comprising the semiconductor element with the diced bonding layer.
According to such a present invention, it is possible to prevent occurrence of pickup defects of the semiconductor elements, to manufacture semiconductor devices in a high yield ratio.

Further, in the method for manufacturing a semiconductor device according to the present invention, it is preferred that the cutting lines are formed so that deepest points thereof are located within the adhesive layer.

Further, in the method for manufacturing a semiconductor device according to the present invention, it is preferred that a cross sectional area of a distal end portion of each cutting line, which extends beyond an interface between the bonding layer and the adhesive layer, is in the range of 5 × 10⁻⁵ to 300 × 10-⁵ mm².

### BRIEF DESCRIPTION OF THE DRAWINGS

FIG. 1 is a view (sectional view) for explaining a first embodiment of the film for semiconductor of the present invention and the method for manufacturing a semiconductor device of the present invention.
FIG. 2 is a view (sectional view) for explaining a first embodiment of the film for semiconductor of the present invention and the method for manufacturing a semiconductor device of the present invention.
FIG. 3 is a view (sectional view) for explaining a first embodiment of the film for semiconductor of the present invention and the method for manufacturing a semiconductor device of the present invention.
FIG. 4 is a view for explaining a method for producing the film for semiconductor of the present invention.
FIG. 5 is a view (sectional view) for explaining a second embodiment of the film for semiconductor of the present invention and the method for manufacturing a semiconductor device of the present invention.
FIG. 6 is a view (sectional view) showing an appearance in which a semiconductor element is picked up using a die bonder, and then mounted onto a substrate.

### MODE FOR CARRYING OUT THE INVENTION

Hereinbelow, a film for semiconductor of the present invention and a method for manufacturing a semiconductor device of the present invention will be described in detail based on preferred embodiments shown in the accompanying drawings.

### <First Embodiment>

First, description will be made on a first embodiment of the film for semiconductor of the present invention and the method for manufacturing a semiconductor device of the present invention.

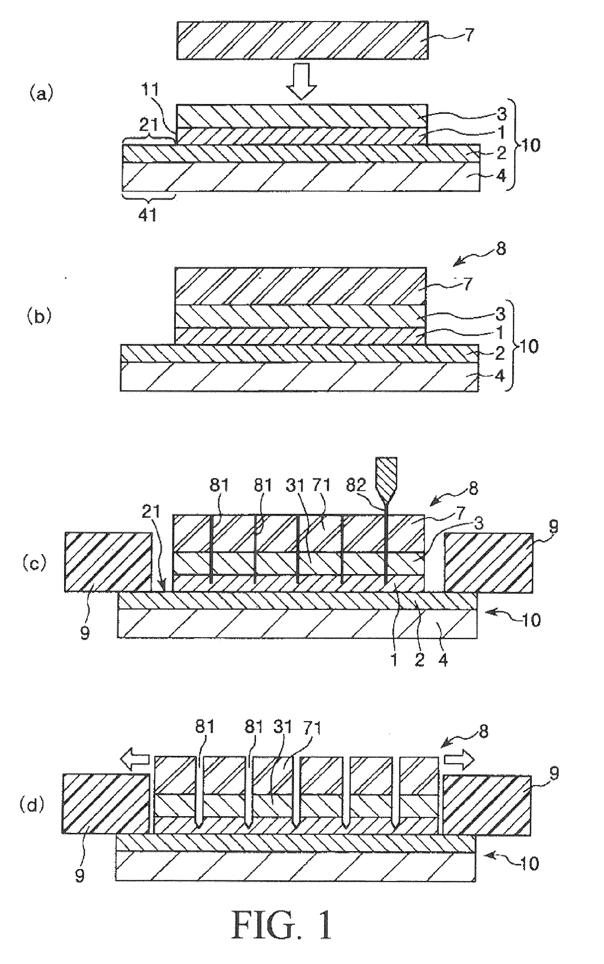

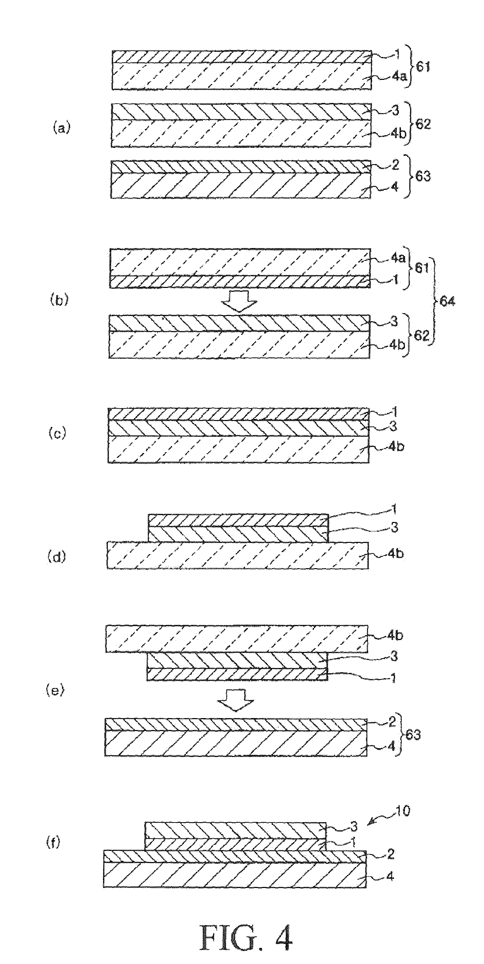

Each of FIGs. 1 to 3 is a view (sectional view) for explaining the first embodiment of the film for semiconductor of the present invention and the method for manufacturing a semiconductor device of the present invention, and FIG. 4 is a view for explaining a method for producing the film for semiconductor of the present invention. In this regard, in the following description, the upper side in each of FIGs. 1 to 4 will be referred to as "upper" and the lower side thereof will be referred to as "lower".

### [Film for Semiconductor]

A film for semiconductor 10 shown in FIG. 1 includes a support film 4, a first adhesive layer 1, a second adhesive layer 2 and a bonding layer 3. More specifically, in the film for semiconductor 10, the second layer 2, the first layer 1 and the bonding layer 3 are laminated together in this order on the support film 4.

Such a film for semiconductor 10 has a function of supporting a semiconductor wafer 7 laminated onto an upper surface of the bonding layer 3 when the semiconductor wafer 7 is separated into semiconductor elements 71 by being diced as shown in FIG. 1(a). Further, the film for semiconductor 10 also has a function of providing a diced bonding layer 31 for bonding the semiconductor element 71 onto an insulating substrate 5 by selectively peeling off the bonding layer 3 from the first adhesive layer 1 when picking up the semiconductor element 71 (that is, the diced semiconductor wafer 7).
Namely, the film for semiconductor 10 is used for picking up a chip 83 in which the semiconductor element 71 and the diced bonding layer 31, which are obtained by dicing the semiconductor wafer 7 and the bonding layer 3, respectively, are laminated together.

Further, a peripheral portion 41 of the support film 4 and a peripheral portion 21 of the second adhesive layer 2 exist beyond and outside a peripheral edge 11 of the first adhesive layer 1, respectively.

A wafer ring 9 is attached onto the peripheral portion 21 among them. This makes it possible for the semiconductor wafer 7 to be reliable supported by the film for semiconductor 10.

Here, the film for semiconductor 10 is **characterized in that** in the case where adhesive strength at 23°C of the first adhesive layer 1 with respect to the bonding layer 3 is defined as "F₂₃ (cN/25mm)" and adhesive strength at 60°C of the first adhesive layer 1 with respect to the bonding layer 3 is defined as "F₆₀ (cN/25mm)", F₂₃ is in the range of 10 to 80 (4 to 32 N/m) and F₆₀/F₂₃ is in the range of 0.3 to 5.5.

Such a film for semiconductor 10 is configured so that a ratio of peel strength at a high temperature (60°C) between the first adhesive layer 1 and the bonding layer 3 to peel strength at a low temperature (23°C) between the first adhesive layer 1 and the bonding layer 3 becomes a predetermined value. Therefore, even in the case where heat is transferred to the chip 83 when being picked up, it is possible to prevent increase of the adhesive property of the first adhesive layer 1 or the second adhesive layer 2, to thereby suppress a pickup property of the chip 83.
As a result, the film for semiconductor 10 can improve a yield ratio of manufacturing semiconductor devices 100 and to manufacture semiconductor devices 100 each having high reliability by preventing occurrence of pickup defects of the chip 83.

Hereinbelow, detail description will be made on a configuration of each part of the film for semiconductor 10 sequentially.

### (First Adhesive Layer)

The first adhesive layer 1 is formed from a general adhesive. Specifically, the first adhesive layer 1 is formed from a first resin composition containing an acryl-based adhesive, a rubber-based adhesive or the like.

Examples of the acryl-based adhesive include a resin constituted from (meth)acrylic acid and ester thereof, a copolymer, obtained by polymerizing (meth)acrylic acid and ester thereof with a copolymerizable unsaturated monomer (e.g., vinyl acetate, styrene, acrylonitrile), and the like. Further, two or more kinds of these resins may be mixed with each other.

Among them, preferable is a copolymer obtained by polymerizing one or more selected from the group consisting of methyl (meth)acrylate, ethyl hexyl (meth)acrylate and butyl (meth)acrylate with one or more selected from the group consisting ofhydroxyethyl (meth)acrylate and vinyl acetate. This makes it possible to easily control an adhesive property or tenacity of the first adhesive layer 1 to an opposing member (adherend) to which the first adhesive layer 1 is allowed to adhere.

Further, the first resin composition may contain urethane acrylate, acrylate monomer or a monomer or oligomer of an isocyanate compound such as a polyvalent isocyanate compound (e.g., 2,4-tolylene diisocyanate, 2,6-tolylene diisocyanate) or the like, in order to control the adhesive property (bonding property) thereof.

Furthermore, in the case where the first adhesive layer 1 is cured by an ultraviolet ray or the like, the first resin composition may contain: an acetophenone-type compound such as methoxy acetophenone, 2,2-dimethoxy-2-phenyl acetophenone, 2,2-diethoxy acetophenone, 2-methyl-1-[4-(methyl thio)-phenyl]-2-morpholino propane-1; a benzophenone-type compound; a benzoin-type compound; a benzoin isobutyl ether-type compound; a benzoin methyl benzoate-type compound; a benzoin benzoic acid-type compound; a benzoin methyl ether-type compound; a benzyl phenyl sulfide-type compound; a benzyl-type compound; a dibenzyl-type compound; a diacetyl-type compound or the like, as a photo polymerization initiator.

Moreover, in order to improve bonding strength and Share strength of the first adhesive layer 1, the first resin composition may contain a tackifier such as rosin resin, terpene resin, coumarone resin, phenol resin, styrene resin, aliphatic-type petroleum resin, aromatic-type petroleum resin, aliphatic aromatic-type petroleum resin, or the like.

An average thickness of such a first adhesive layer 1 is not limited to a specific value, but is preferably in the range of about 1 to 100 µm, and more preferably in the range of about 3 to 50 µm. If the thickness is less than the above lower limit value, there is a case that it is difficult to maintain the adhesive strength of the first adhesive layer 1 sufficiently. On the other hand, even if the thickness exceeds the above upper limit value, the properties of the first adhesive layer 1 are not substantially changed, and any advantages also cannot be obtained.
If the thickness falls within the above range, the first adhesive layer 1 cannot be peeled off from the bonding layer 3 when being diced and can be peeled off therefrom relatively easily according to a tensile load when being picked up, namely, the first adhesive layer 1 can exhibit a excellent dicing property and a superior pickup property.

### (Second Adhesive Layer)

The second adhesive layer 2 has an adhesive property higher than that of the first adhesive layer 1. Therefore, adhesion of the wafer ring 9 with respect to the second adhesive layer 2 becomes stronger than adhesion of the bonding lawyer 3 with respect to the first adhesive layer 1. This makes it possible to reliably fix the wafer ring 9 to the second adhesive layer 2 when dicing the semiconductor wafer 7 to separate into the semiconductor elements 71 during a second step. As a result, displacement of the semiconductor wafer 7 can be reliably prevented, to thereby suppress dimensional accuracy of the semiconductor elements 71 from being lowered.

As the second adhesive layer 2, one similar to the above first adhesive layer 1 can be used. Specifically, the second adhesive lawyer 2 is formed from a second resin composition containing an acryl-based adhesive, a rubber-based adhesive or the like.

Examples of the acryl-based adhesive include a resin constituted from (meth)acrylic acid and ester thereof, a copolymer obtained by polymerizing (meth)acrylic acid and ester thereof with a copolymerizable unsaturated monomer (e.g., vinyl acetate, styrene, acrylonitrile), and the like. Further, two or more kinds of these resins may be mixed with each other.

Among them, preferable is a copolymer obtained by polymerizing one or more selected from the group consisting of methyl (meth)acrylate, ethyl hexyl (meth)acrylate and butyl (meth)acrylate with one or more selected from the group consisting ofhydroxyethyl (meth)acrylate and vinyl acetate. This makes it possible to easily control an adhesive property or tenacity of the second adhesive layer 2 to an opposing member (adhered) to which the second adhesive layer 2 is allowed to adhere.

Further, the second resin composition may contain urethane acrylate, acrylate monomer or a monomer or oligomer of an isocyanate compound such as a polyvalent isocyanate compound (e.g., 2,4-tolylene diisocyanate, 2,6-tolylene diisocyanate) or the like, in order to control the adhesive property (bonding property) thereof.

Furthermore, the second adhesive composition may contain the same photo polymerization initiator as described in the first adhesive composition.

Moreover, in order to improve a bonding strength and Share strength of the second adhesive layer 2, the second resin composition may contain a tackifier such as rosin resin, terpene resin, coumarone resin, phenol resin, styrene resin, aliphatic-type petroleum resin, aromatic-type petroleum resin, aliphatic aromatic-type petroleum-resin, or the like.

An average thickness of such a second adhesive layer 2 is not limited to a specific value, but is preferably in the range of about 1 to 100 µm, and more preferably in the range of about 3 to 20 µm. If the thickness is less than the above lower limit value, there is a case that it is difficult to maintain the adhesive strength of the second adhesive layer 2 sufficiently. On the other hand, even if the thickness exceeds the above upper limit value, the second adhesive layer 2 cannot exhibit especially excellent effects.
Further, the second adhesive layer 2 has plasticity higher than that of the first adhesive layer 1. Therefore, if the average thickness of the second adhesive layer 2 falls within the above range, a shape-following property of the second adhesive layer 2 can be maintained, to thereby further improve the adhesive property of the film for semiconductor 10 with respect to the semiconductor wafer 7.

### (Bonding Layer)

The bonding layer 3 is, for example, formed of a third resin composition containing a thermoplastic resin and a thermosetting resin. Such a resin composition has a good film-forming property, an excellent bonding property and superior heat resistance after being cured.

Examples of the thermoplastic resin include: a polyimide-based resin such as polyimide resin or polyetherimide resin; a polyamide-based resin such as polyimide resin or polyamideimide resin; an acryl-based resin; phenoxy resin; and the like. Among them, the acryl-based resin is preferable. Since the acryl-based resin has a low glass transition temperature, it is possible to further improve an initial adhesive property of the bonding layer 3.

In this regard, it is to be noted that the acryl-based resin means a polymer of acrylic acid and derivatives thereof. Specifically, examples of the acryl-based resin include a polymer of acrylic acid, methacrylic acid, an acrylate such as methyl acrylate or ethyl acrylate, a methacrylate such as methyl methacrylate or ethyl methacrylate, acrylonitrile, acryl amide, or the like, a copolymer, obtained by polymerizing such a monomer with another monomer, and the like.

Further, among these acryl-based resins, preferable is an acryl-based resin (especially, an acrylate copolymer) containing a compound (copolymerizable monomer component) having a functional group such as an epoxy group, a hydroxyl group, a carboxyl group or a nitrile group. This makes it possible to further improve the adhesive property of the bonding layer 3 to the adhered such as the semiconductor element 71.
Specifically, examples of the compound having the functional group include glycidyl methacrylate having a glycidyl ether group, hydroxyl methacrylate having a hydroxyl group, carboxyl methacrylate having a carboxyl group, acrylonitrile having a nitride group, and the like.

Furthermore, an amount of the compound having the functional group contained in the third resin composition is not limited to a specific value, but is preferably in the range of about 0.5 to 40 wt%, and more preferably in the range of about 5 to 30 wt% with respect to a total amount of the acryl-based resin. If the amount is less than the above lower limit value, there is a case that the effect of improving the adhesive property of the bonding layer 3 is lowered. On the other hand, if the amount exceeds the above upper limit value, there is a case that the adhesive strength of the bonding layer 3 becomes too large so that an effect of improving a working property is lowered.

Moreover, a glass transition temperature Tg of the thermoplastic resin is not limited to a specific value, but is preferably in the range of -25 to 120°C, more preferably in the range of -20 to 60°C, and even more preferably in the range of -10 to 50°C. If the glass transition temperature is less than the above lower limit value, there is a case that the adhesive sterngth of the bonding layer 3 becomes too large so that an effect of improving a working property is lowered. On the other hand, if the glass transition temperature exceeds the above upper limit value, there is a case that the effect of improving an adhesive property of the bonding layer 3 at a low temperature is lowered.

In addition, a weight average molecular weight of the thermoplastic resin (especially, the acryl-based resin) is not limited to a specific value, but is preferably 100,000 or more, and more preferably in the range of 150,000 to 1,000,000. If the weight average molecular weight falls within the above range, it is possible to especially improve the film-forming property of the bonding layer 3.

On the other hand, examples of the thermosetting resin include: a novolac-type phenol resin such as phenol novolac resin, cresol novolac resin, bisphenol A novolac resin; a phenol resin such as resol phenol resin; an epoxy resin such as a bisphenol-type epoxy resin (e.g., bisphenol A epoxy resin, bisphenol F epoxy resin), a novolac-type epoxy resin (e.g., novolac epoxy resin, cresol novolac epoxy resin), a biphenyl-type epoxy resin, a stilbene-type epoxy resin, a triphenol methane-type epoxy resin, an alkyl-modified triphenol methane-type epoxy resin, a triazine chemical structure-containing epoxy resin or a dicyclopentadiene-modified phenol-type epoxy resin; a resin containing a triazine ring such as urea resin or a melamine resin; an unsaturated-polyester resin; a bismaleimide resin; a polyurethane resin; a diallyl phthalate resin; a silicone resin; a resin containing a benzoxazine chemical structure; a cyanate ester resin; and the like. A mixture containing one or more of them also may be used.
Further, among them, the epoxy resin or the phenol resin is preferable. By using these resins, it is possible to further improve the heat resistance and the adhesive property of the bonding layer 3.

Further, an amount of the thermosetting resin contained in the third resin composition is not limited to a specific value, but is preferably in the range of about 1 to 400 parts by weight, and more preferably in the range of about 3 to 300 parts by weight with respect to 100 parts by weight of the thermoplastic resin. If the amount exceeds the above upper limit value, there is a case that chipping and crack are generated in the bonding layer 3 or a case that the effect of improving the effect of improving the adhesive property of the bonding layer 3 is lowered. On the other hand, if the amount is less than the above lower limit value, there is a case that the adhesive strength of the bonding layer 3 becomes too large so that pickup defects occur or the effect of improving the working property is lowered.

Furthermore, it is preferred that the third resin composition further contains a curing agent (especially, a phenol-based curing agent in the case of the thermosetting resin being the epoxy resin).

Examples of the curing agent include: an amine-type curing agent such as an aliphatic polyamine (e.g., diethylene triamine (DETA), triethylene tetramine (TETA), metaxylylene diamine (MXDA)), an aromatic polyamine (e.g., diamino diphenyl methane (DDM), m-phenylene diamine (MPDA), diamino diphenyl sulfone (DDS)), dicyandiamide (DICY) or a polyamine compound containing organic acid dihydrazide; an acid anhydride-type curing agent such as an aliphatic acid anhydride (liquid acid anhydride) (e.g., hexahydro phthalic anhydride (HHPA), methyl tetrahydro phthalic acid anhydride (MTHPA)) or an aromatic acid anhydride (e.g., trimellitic acid anhydride (TMA), pyromellitic acid dianhydride (PMDA), benzophenone tetracarboxylic acid dianhydride (BTDA)); or a phenol-type curing agent such as phenol resin.
Among them, the phenol-type curing agent is preferable. Specifically, examples of the phenol-type curing agent include: bisphenols such as bis(4-hydroxy-3,5-dimethyl phenyl) methane (common name: tetramethyl bisphenol F), 4,4'-sulfonyl diphenyl, 4,4'-isopropylidene diphenol (common name: bisphenol A ), bis (4-hydroxyphenyl) methane, bis(2-hydroxyphenyl) methane, (2-hydroxyphenyl) (4-hydroxyphenyl) methane and a mixture of the bis(4-hydroxyphenyl) methane, the bis(2-hydroxyphenyl) methane and the (2-hydroxyphenyl) (4-hydroxyphenyl) methane (e.g., "bisphenol F-D" produced by Honshu Chemical Industry Co., Ltd.); dihydroxybenzenes such as 1,2-benzenediol, 1,3-benzenediol and 1,4-benzenediol; trihydroxybenzenes such as 1,2,4-benzenetriol; various isomers of dihydroxynaphthalenes such as 1,6-dihydroxynaphthalene; various isomers of biphenols such as 2,2'-biphenol and 4,4'-biphenol; and the like.

Further, an amount of the curing agent (especially, the phenol-based curing agent) contained in the third resin composition is not limited to a specific value, but is preferably in the range of 1 to 200 parts by weight, and more preferably in the range of about 3 to 150 parts by weight with respect to 100 parts by weight of the thermoplastic resin. If the amount is less than the above lower limit value, there is a case that the effect of improving the heat resistance of the bonding layer 3 is lowered. On the other hand, if the amount exceeds the above upper limit value, there is a case that storage stability of the bonding layer 3 is lowered.

Furthermore, in the case where the above mentioned thermosetting resin is the epoxy resin, a ratio between an epoxy equivalent and an equivalent of the curing agent can be determined by calculation. Specifically, a ratio of the epoxy equivalent of the epoxy resin to the equivalent of the functional group of the curing agent (e.g., a hydroxyl equivalent in the case of the phenol resin) is preferably in the range of 0.5 to is and more preferably in the range of 0.7 to 1.3. If the ratio is less than the above lower limit value, there is a case that the storage stability of the bonding layer 3 is lowered. On the other hand, if the ratio exceeds the above upper limit value, there is a case that the effect of improving the heat resistance of the bonding layer 3 is lowered.

In addition, it is preferred that the third resin composition further contains a curing catalyst (accelerator), if needed. This makes it possible to improve curability of the bonding layer 3.

Examples of the curing catalyst include an amine-type catalyst such as imidazoles, 1,8-diazabicyclo(5,4,0)undecene, a phosphorous-type catalyst such as triphenyl phosphine, and the like. Among them, the imidazoles are preferable. This makes it possible for the bonding layer 3 to especially combine fast curability and the storage stability.

Examples of the imidazoles include 1-benzyl-2-methyl imidazole, 1-benzyl-2-phenyl imidazole, 1-cyanoethyl-2-ethyl-4-methyl imidazole, 2-phenyl-4-methyl imidazole, 1-cyanoethyl-2-phenyl imidazolium trimellitate, 2,4-diamino-6-[2'-methyl imidazolyl-(1')]-ethyl-s-triazine, 2,4-diamino-6-[2'-undecyl imidazolyl-(1')]-ethyl-s-triazine, 2,4-diamino-6-[2'-ethyl-4'-methyl imidazolyl-(1')]-ethyls-triazine, 2,4-diamino-6-[2'-methyl imidazolyl-(1')]-ethyl-s-triazine isocyanurate adduct, 2-phenyl imidazole isocyanurate adduct, 2-phenyl-4,5-dihydroxymethyl imidazole, 2-phenyl-4-methyl-5-dihydroxymethyl imidazole, 2,4-diamino-6-vinyl-s-triazine, 2,4-diamino-6-vinyl-s-triazine isocyanurate adduct, 2,4-diamino-6-methacryloyloxyethyl-s-triazine, 2,4-diamino-6-methacryloyloxyethyl-s-triazine isocyanurate adduct, and the like.
Among them, the 2-phenyl-4,5-dihydroxymethyl imidazole or the 2-phenyl-4-methyl-5-dihydroxymethyl imidazole is preferable. This makes it possible to especially improve the storage stability of the bonding layer 3.

Further, an amount of the curing catalyst contained in the third resin composition is not limited to a specific value, but is preferably in the range of about 0.01 to 30 parts by weight, and more preferably in the range of about 0.5 to 10 parts by weight with respect to 100 parts by weight of the thermoplastic resin. If the amount is less than the above lower limit value, there is a case that the curability of the bonding layer 3 is insufficient. On the other hand, if the amount exceeds the above upper limit value, there is a case that the storage stability of the bonding layer 3 is lowered.

Furthermore, an average particle size of the curing catalyst is not limited to a specific value, but is preferably 10 µm or less, and more preferably in the range of 1 to 5 µm. If the average particle size falls within the above range, the curing catalyst can especially exhibit excellent reactivity.

Moreover, it is preferred that the third resin composition further contains a coupling agent, if needed. This makes it possible to further improve adhesive strength between a resin and an adhered and adhesive strength of a resin interface.

Examples of the coupling agent include a silane-type coupling agent, a titanium-type coupling agent, an aluminum-type coupling agent, and the like. Among them, the silane-type coupling agent is preferable. This makes it possible to further improve the heat resistance of the bonding layer 3.

Examples of the silane-type coupling agent include vinyl trichlorosilane, vinyl trimethoxysilane, vinyl triethoxysilane, β-(3,4-epoxycyclohexyl) ethyl trimethoxysilane, γ-glycidoxypropyl trithoxysilane, γ-glycidoxypropyl methyl diethoxysilane, γ-methacryloxypropyl trimethoxysilane, γ-methacryloxypropyl methyl diethoxysilane, γ-methacryloxypropyl triethoxysilane, N-β-(aminoethyl) γ-aminopropyl methyl dimethoxysilane, N-β-(aminoethyl) γ-aminopropyl trimethoxysilane, N-β-(aminoethyl) γ-aminopropyl triethoxysilane, γ-aminopropyl trimethoxysilane, γ-aminopropyl triethoxysilane, N-phenyl-γ-aminopropyl trimethoxysilane, γ-chloropropyl trimethoxysilane, γ-mercaptopropyl trimethoxysilane, 3-isocyanatepropyl triethoxysilane, 3-acryloxypropyl trimethoxysilane, bis(3-triethoxysilyl propyl) tetrasulfane, and the like.

An amount of the coupling agent contained in the third resin composition is not limited to a specific value, but is preferably in the range of about 0.01 to 10 parts by weight, and more preferably in the range of about 0.5 to 10 parts by weight with respect to 100 parts by weight of the thermoplastic resin. If the amount is less than the above lower limit value, there is a case that the adhesive effect of the bonding layer 3 is insufficient. On the other hand, the amount exceeding the above upper limit value causes generation of outgases or voids within the bonding layer 3.

When the bonding layer 3 is formed, the bonding layer 3 can be obtained by dissolving such a third resin composition into a solvent such as methyl ethyl ketone, acetone, toluene or dimethyl formamide to bring into a vanish state, applying the same onto a carrier film using a comma coater, a die coater, a gravure coater or the like, and then drying it.

An average thickness of the bonding layer 3 is not limited to a specific value, but is preferably in the range of about 3 to 100 µm, and more preferably in the range of about 5 to 70 µm. If the thickness falls within the above range, it is possible to control thickness accuracy of the bonding layer 3 in a very easy manner.

Further, the third resin composition may contain a filler, if needed. By containing the filler in the third resin composition, it is possible to improve a mechanical property and a bonding property of the bonding layer 3.

Examples of the filler include particles made of silver, titanium oxide, silica, mica or the like.

Further, an average particle size of the filler is preferably in the range of about 0.1 to 25 µm. If the average particle size is less than the above lower limit value, the effect of adding the filler to the third resin composition is lowered. On the other hand, if the average particle size exceeds the above upper limit value, there is a possibility that the bonding property of the bonding layer 3 required as the film is lowered.

An amount of the filler contained in the third resin composition is not limited to a specific value, but is preferably in the range of about 0.1 to 100 parts by weight, and more preferably in the range of about 5 to 90 parts by weight with respect to 100 parts by weight of the thermoplastic resin. This makes it possible to further improve the bonding property of the bonding layer 3 while enhancing the mechanical property thereof.

### (Support film)

The support film 4 is a base material for supporting the first adhesive layer 1, the second adhesive layer 2 and the bonding layer 3 as described above.

Examples of a constituent material of the support film 4 include polyethylene, polypropylene, polybutene, polybutadiene, polymethyl pentene, polyvinyl chloride, vinyl chloride copolymer, polyethylene terephthalate, polybutylene terephthalate, polyurethane, ethylene-vinyl acetate copolymer, ionomer, ethylene-(meth)acrlylic acid copolymer, ethylene-(meth)acrlylate copolymer, polystyrene, vinyl polyisoprene, polycarbonate and the like, and a mixture containing two or more of them and the like.

An average thickness of the support film 4 is not limited to a specific value, but is preferably in the range of about 5 to 200 µm, and more preferably in the range of about 30 to 150 µm. In this case, since the support film 4 has appropriate rigidity, it can reliably support the first adhesive layer 1, the second adhesive layer 2 and the bonding layer 3. This makes it possible to easily handle the film for semiconductor 10. Further, this also makes it possible for the film for semiconductor 10 to be bent appropriately, to thereby improve the adhesive property of the bonding layer 3 to the semiconductor wafer 7.

### (Properties of Film for Semiconductor)

Although the first adhesive layer 1, the second adhesive layer 2 and the bonding layer 3 have different adhesive strengths, respectively, they preferably have the following properties.

First, it is preferred that the adhesive strength of the first adhesive layer 1 with respect to the bonding layer 3 is smaller than the adhesive strength of the second adhesive layer 2 with respect to the wafer ring 9. In this case, when the chip 83 is picked up during a third step described below, the wafer ring 9 is not peeled off from the second adhesive layer 2, but the bonding layer 3 is selectively peeled off from the first adhesive layer 1. Further, the wafer ring 9 can reliably support (fix) a laminated body 8 when being diced.

Namely, since the two adhesive layers including the first adhesive layer 1 and the second adhesive layer 2 are used in this embodiment, by making the adhesive strengths thereof different from each other, it is possible to combine the reliable fixation of the laminated body 8 and the easy pickup of the chip 83. In other words, it is possible to balance between the dicing property and the pickup property of the film for semiconductor 10.

In this regard, it is to be noted that the adhesive strength of the first adhesive layer 1 with respect to the bonding layer 3 and the adhesive strength of the second adhesive layer 2 with respect to the wafer ring 9 can be adjusted by changing the kind (formulation) of the acryl-based resin, the kind of the monomer, the amounts thereof, hardness and the like.

Further, the adhesive strength of the first adhesive layer 1 with respect to the bonding layer 3 before being diced is not limited to a specific value, but is preferably in the range of about 10 to 80 cN/25mm (4 to 32 N/m), and more preferably in the range of about 30 to 60 cN/25mm (12 to 24 N/m) as an average value at an adhesive interface therebetween. If the adhesive strength falls within the above range, it is possible to prevent defects such as removal of the semiconductor element 71 from the first adhesive layer 1 when the laminated body 8 is extended (expanded) or diced as described below, and to maintain the excellent pickup property of the film for semiconductor z.

In this regard, it is to be noted that the adhesive strength (cN/25mm) indicates a load (unit: cN) measured by forming a sample (laminated film) in which the bonding layer 3 has attached to a surface of the first adhesive layer 1 into a strip shape having a width of 25 mm, and then removing a portion corresponding to the bonding layer 3 from the sample at a peel off angle of 180° and a pull speed of 1,000 mm/min and at 23°C (room temperature). Namely, herein, the adhesive strength of the first adhesive, layer 1 with respect to the bonding layer 3 is defined as "180° peel strength".

Examples of a formulation of the first adhesive layer 1 having the property described above include a mixture containing 1 to 50 parts by weight of the acrylate monomer and 0.1 to 10 parts by weight of the isocyanate compound with respect to 100 parts by weight of the acryl-based resin.

On the other hand, the adhesive strength of the second adhesive layer 2 with respect to the wafer ring 9 is not limited to a specific value, but is preferably in the range of about 100 to 2,000 cN/25mm (40 to 800 N/m), and more preferably in the range of about 400 to 1,200 cN/25mm (160 to 480 N/m) as an average value at an adhesive interface therebetween. If the adhesive strength falls within the above range, it is possible to prevent defects such as removal of the semiconductor element 71 from the first adhesive layer 1, which would be resulted from prevention of peel off of the first adhesive layer 1 from the second adhesive layer 2 at the interface therebetween, when the laminated body 8 is extended (expanded) or diced as described below, and to reliably support (fix) the laminated body 8 by the wafer ring 9.

In this regard, it is to be noted that the adhesive strength (cN/25mm) indicates a load (unit: cN) measured by attaching a strip adhesive tape having a width of 25 mm to an upper surface of the wafer ring 9 at 23°C (room temperature), and then peeling off the adhesive tape from the wafer ring 9 at a peel off angle of 180° and a pull speed of 1,000 mm/min and at 23°C (room temperature). Namely, herein, the adhesive strength of the second adhesive layer 2 with respect to the wafer ring 9 is defined as "180° peel strength".

Examples of a formulation of the second adhesive layer 2 having the property described above include a mixture containing 1 to 50 parts by weight of the urethane acrylate and 0.5 to 10 parts by weight of the isocyanate compound with respect to 100 parts by weight of the acryl-based resin.

In this regard, in the case where the adhesive strength of the first adhesive layer 1 with respect to the bonding layer 3 is defined as "A₁" and the adhesive strength of the second adhesive layer 2 with respect to the first adhesive layer 1 is defined as "A₂", A₂/A₁ is not limited to a specific value, but is preferably in the range of about 5 to 200, and more preferably in the range of about 10 to 50. This makes it possible for the first adhesive layer 1, the second adhesive layer 2 and the bonding layer 3 to especially exhibit the excellent dicing property and the superior pickup property.

Further, it is preferred that the adhesive strength of the first adhesive layer 1 with respect to the bonding layer 3 is smaller than the adhesive strength of the bonding layer 3 with respect to the semiconductor wafer 7. This makes it possible to prevent the semiconductor wafer 7 from being involuntarily peeled off from the bonding layer 3 at the interface therebetween when the chip 83 is picked up. Namely, this makes it possible to selectively peel off the bonding layer 3 from the first adhesive layer 1 at the interface therebetween.

In this regard, it is to be noted that the adhesive strength of the bonding layer 3 with respect to the semiconductor wafer 7 is not limited to a specific value, but is preferably in the range of about 50 to 500 cN/25mm (20 to 200 N/m), and more preferably in the range of about 80 to 250 cN/25mm (32 to 100 N/m). In the adhesive strength falls within the above range, it is possible to sufficiently prevent jump and removal of the semiconductor elements 71, so-called "chip jump", from occurring.

Further, it is preferred that the adhesive strength of the first adhesive layer 1 with respect to the bonding layer 3 is smaller than the adhesive strength of the first adhesive layer 1 with respect to the second adhesive layer 2. This makes it possible to prevent the first adhesive layer 1 from being involuntarily peeled off from the second adhesive layer 2 at the interface therebetween when the chip 83 is picked up. Namely, this makes it possible to selectively peel off the first adhesive layer 1 from the second adhesive layer 2 at the interface therebetween.

In this regard, it is to be noted that the adhesive strength of the first adhesive layer 1 with respect to the second adhesive layer 2 is not limited to a specific value, but is preferably in the range of about 100 to 1,000 cN/25mm (40 to 400 N/m), and more preferably in the range of about 300 to 600 cN/25mm (120 to 240 N/m). If the adhesive strength falls within the above range, it is possible to make the dicing property and the pickup property of the film for semiconductor 10 especially excellent.

### (Method for Producing Film for Semiconductor)

The film for semiconductor 10 as described above can be produced using, for example, the following method.

First, a base member 4a shown in FIG. 4 (a) is prepared, and then the first adhesive layer 1 is formed on one surface of the base member 4a. In this way, a laminated body 61 including the base member 4a and the first adhesive layer 1 is obtained. The formation of the first adhesive layer 1 can be carried out using a method in which a resin varnish containing the above mentioned first resin composition is applied onto the base member 4a by various kinds of application methods to obtain a coating film, and then the coating film is dried, a method in which a film formed of the first resin composition is laminated onto the base member 4a, or the like. Further, the coating film may be cured by being irradiated with a radial ray such as an ultraviolet ray.

Examples of the application methods include a knife coating method, a roll coating method, a spray coating method, a photogravure coating method, a bar coating method, a curtain coating method and the like.

Further, as shown in FIG. 4(a), the bonding layer 3 is formed on one surface of a prepared base member 4b in the same manner as the laminated body 61. In this way, a laminated body 62 including the base member 4b and the bonding layer 3 is obtained.

Furthermore, as shown in FIG. 4(a), the second adhesive layer 2 is formed on one surface of the prepared support film 4 in the same manner as each of the laminated body 61 and the laminated body 62. In this way, a laminated body 63 including the support film 4 and the second adhesive layer 2 is obtained.

Next, as shown in FIG. 4(b), the laminated body 61 is laminated onto the laminated body 62 so that the first adhesive layer 1 makes contact with the bonding layer 3, to thereby obtain a laminated body 64. This lamination can be carried out using, for example, a roll lamination method or the like.

Next, as shown in FIG. 4(c), the base member 4a is removed from the laminated body 64. Then, as shown in FIG. 4(d), a ring-shaped region outside an effective area of the bonding layer 3 and the first adhesive layer 1 is removed from the laminated body 64 without the base member 4a so as to leave the base member 4b. Here, the effective region is defined as a region having an outer diameter which is larger than an outer diameter of the semiconductor wafer 7 and is smaller than an inner diameter of the wafer ring 9.

Next, as shown in FIG. 4(e), the laminated body 64, from which the base member 4a and the ring-shaped region outside the effective area have been removed, is laminated onto the laminated body 63 so that an exposed surface of the first adhesive layer 1 makes contact with the second adhesive layer 2. Thereafter, by peeling off the base member 4b from the bonding layer 3, the film for semiconductor 10 shown in TIG. 4(f) can be obtained.

### [Method for Manufacturing Semiconductor Device]

Next, description will be made on a method for manufacturing a semiconductor device 100 using the film for semiconductor 10 described above (that is, a first embodiment of the semiconductor device manufacturing method according to the present invention).

A semiconductor device manufacturing method shown in FIGs. 1 to 3 includes: a first step of laminating the semiconductor wafer 7 onto the film for semiconductor 10 to obtain the laminated body 8; a second step of forming cutting lines 81 into the laminated body 8 (dicing the semiconductor wafer 7) from a side of the semiconductor wafer 7 in a state that the wafer ring 9 is attached to a peripheral portion 21 of the film for semiconductor 10 so that the semiconductor wafer 7 and the bonding layer 3 are separated into a plurality of chips 83 each including the semiconductor element 71 and the diced bonding layer 31; a third step of picking up at least one chip 83; and a fourth step of mounting the picked up chip 83 onto an insulating substrate 5, to thereby obtain a semiconductor device 100.
Hereinbelow, each of the above steps will be sequentially described in detail.

[1]
[1-1] First, the semiconductor wafer 7 and the film for semiconductor 10 are prepared.

The semiconductor wafer 7 has a plurality of circuits which have, in advance, formed on a surface thereof. Examples of such a semiconductor wafer 7 include a compound semiconductor wafer such as a gallium arsenide semiconductor wafer or a gallium nitride semiconductor wafer in addition to a silicon wafer.

An average thickness of such a semiconductor wafer 7 is not limited to a specific value, but is preferably in the range of about 0.01 to 1 mm, and more preferably in the range of about 0.03 to 0.5 mm. According to the semiconductor device manufacturing method of the present invention, it is possible to dice the semiconductor wafer 7 having such a thickness easily and reliably without generating the defects such as the breakage and the crack therein.

[1-2] Next, as shown in FIG. 1(a), the semiconductor wafer 7 is laminated onto the film for semiconductor 10 described above so that the semiconductor wafer 7 makes close contact with the bonding layer 3 of the film for semiconductor 10 (that is, this step is the first step).
In this regard, it is to be noted that in the film for semiconductor 10 shown in FIG. 1, the shape of the bonding layer 3 at a plane view thereof has been, in advance, set to a shape having a size (outer diameter) which is larger than an outer diameter of the semiconductor wafer 7 and is smaller than the inner diameter of the wafer ring 9. Therefore, the whole lower surface of the semiconductor wafer 7 makes close contact with the whole upper surface of the bonding layer 3. In this way, it becomes possible for the semiconductor wafer 7 to be supported by the film for semiconductor 10.

As a result of the above lamination, as shown in FIG. 1(b), it is possible to obtain a laminated body 8 in which the semiconductor wafer 7 and the film for semiconductor 10 are laminated together.

[2]
[2-1] Next, the wafer ring 9 is prepared. Thereafter, the wafer ring 9 is laminated onto the laminated body 8 so that a lower surface of the wafer ring 9 makes close contact with an upper surface of the peripheral portion 21 of the second adhesive layer 2. In this way, a peripheral portion of the laminated body 8 is supported (secured) by the wafer ring 9.

The wafer ring 9 is generally formed of various kinds of metal materials such as stainless steel and aluminum. Therefore, since the wafer ring 9 has high rigidity, it is possible reliably to present deformation of the laminated body 8.

Since the film for semiconductor 10 includes the two adhesive layers (that is, the first adhesive layer 1 and the second adhesive layer 2) having the different adhesive strengths, it is possible for the film for semiconductor 10 to balance between the dicing property and the pickup property by utilizing the different adhesive strengths.

[2-2] Next, prepared is a dicer table not shown in the drawings. The laminated body 8 is placed onto the dicer table so that the support film 4 makes contact with the dice table.

Thereafter, as shown in FIG. 1(c), the plurality of cutting lines 81 are formed into the laminated body 8 (diced) using a dicing blade 82. The dicing blade 82 is formed from a disciform diamond blade or the like. The cutting lines 81 are formed by pressing the dicing blade 82 against a surface of the laminated body 8 located at a side of the semiconductor wafer 7 while rotating it. By relatively moving the dicing blade 82 with respect to the laminated body 8 along each space between the circuits formed on the semiconductor wafer 7, the semiconductor wafer 7 is diced into the plurality of semiconductor elements 71 (that is, this step is the second step).
Further, the bonding layer 3 is also diced into the plurality of diced bonding layers 31. Although vibration and impact are imparted to the semiconductor wafer 7 when being diced, since the lower surface of the semiconductor wafer 7 is supported by the film for semiconductor 10, the above vibration and impact can be absorbed. As a result, it is possible to reliably prevent the occurrence of the defects such as the breakage and the crack in the semiconductor wafer 7.

A depth of each cutting line 81 is not limited to a specific value as long as it passes through the semiconductor wafer 7 and the bonding layer 3. Namely, a distal end of each cutting line 81 has only to come down to either the first adhesive layer 1, the second adhesive layer 2 or the support film 4. This makes it possible to reliably dice the semiconductor wafer 7 and the bonding layer 3, respectively, to thereby form the semiconductor elements 71 and the diced bonding layers 31.

In this regard, in this embodiment, as shown in FIG. 1(c), description will be made on a case that the distal end of each cutting line 81 comes down up to the support film 4.

[3]
[3-1] Next, the laminated body 8 into which the plurality of cutting lines 82 have been formed is extended (expanded) in a radial pattern using a expander not shown in the drawings. In this way, as shown in FIG. 1(d), a pitch between the semiconductor elements 71 obtained by the dicing is widened in association with enlargement of a width of each cutting line 82. As a result, it is possible to prevent a semiconductor element 71 from interfering in another semiconductor element 71. This makes it possible to easily pick up the individual semiconductor elements 71.
In this regard, it is to be noted that the expander is configured so that the expanded state of the laminated body 8 also can be kept during steps described below.

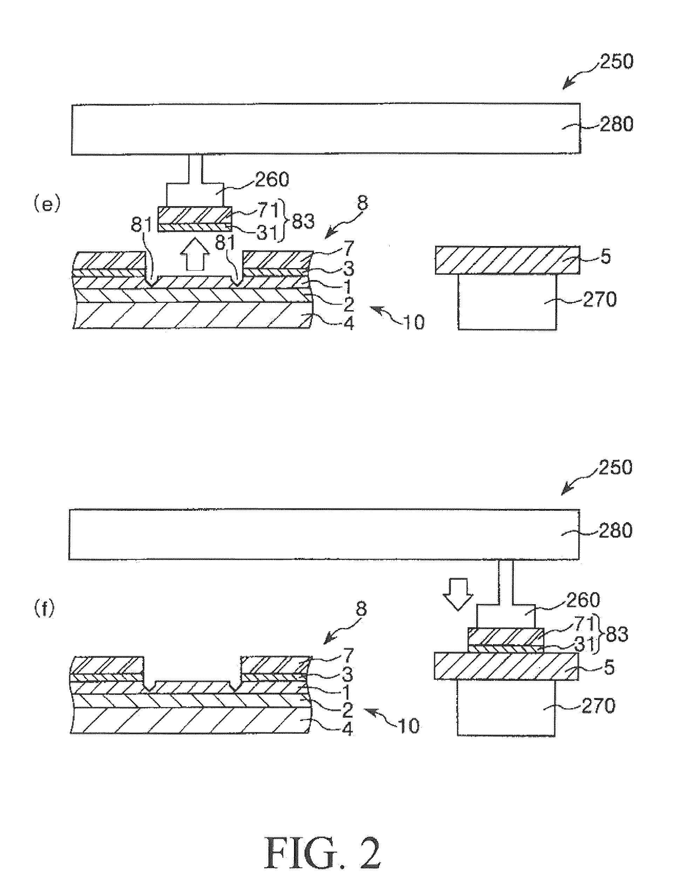

[3-2] Next, one of the semiconductor elements 71 obtained by the dicing is adsorbed and pulled up using a die bonder 250 shown in FIG. 2. As a result, as shown in FIG. 2(e), the diced bonding layer 31 is selectively peeled off from the first adhesive layer 1 at the interface therebetween so that the chip 83, in which the semiconductor element 71 and the diced bonding layer 31 are laminated together, is picked up (that is, this step is the third step).

[4]
[4-1] Next, the insulating substrate 5 for mounting the semiconductor element 71 (chip) thereonto is prepared.

Examples of the insulating substrate 5 include a substrate having an insulating property on which the semiconductor element 71 can be mounted and provided with wirings (circuits), terminals and the like for electrically connecting the semiconductor element 71 to external elements.

Concrete examples of the insulating substrate 5 include: a flexible substrate such as a polyester copper-clad film substrate, a polyimide copper-clad film substrate or an alamido copper-clad film substrate; a rigid substrate such as a glass base copper-clad laminated substrate (e.g., a glass fabric-epoxy copper-clad laminated substrate), a composite copper-clad laminated substrate (e.g., a glass nonwoven fabric-epoxy copper-clad laminated substrate) or a heat resistant-thermoplastic substrate (e.g., a polyetherimide resin substrate, a polyether ketone resin substrate, a polysulfone-based resin substrate); a ceramics substrate such as an alumina substrate, an aluminium nitride substrate or a silicon carbide substrate; and the like.
In this regard, it is to be noted that a lead frame or the like may be used instead of the insulating substrate 5.

Thereafter, as shown in FIG. 2(f), the picked up chip 83 is mounted onto the insulating substrate 5.

Here, a die bonder 250 is described.
As shown in FIG. 2, the die bonder 250 picks up the chips 83 obtained through the dicing step, and transfers them onto the insulating substrate 5 described below.

This die bonder 250 includes a collet (chip absorption section) 260 for absorbing the chip 230, a heater 270 for heating the insulating substrate 5 from a lower side thereof, an equipment main body 280 for holding the collet 260 so as to be freely moved. The collet 260 is configured so as to be transferred from a stage for mounting the laminated body 8 to a stage for mounting the insulating substrate 5 in the state of absorbing the chip 83.

During this step, as shown in FIG. 2(e), the chip 83 is picked up by the collet 260, and then mounted onto the insulating substrate 5. Thereafter, the chip 83 is pressed onto the insulating substrate 5 while being heated by the heater 270 so that the chip 83 is bonded to the insulating substrate 5 (see FIG. 2(f)).

In this regard, the reason why the diced bonding layer 31 is selectively peeled off from the first adhesive layer 1 at the interface therebetween is because the adhesive strength of the interface between the support film 4 and the second adhesive layer 2 and the adhesive strength of the interface between the second adhesive layer 2 and the first adhesive layer 1 are larger than the adhesive strength of the interface between the first adhesive layer 1 and the bonding layer 3 due to the adhesive property of the second adhesive layer 2 higher than the adhesive property of the first adhesive layer 1. Namely, in the case where the semiconductor element 71 is picked up upward, the bonding layer 3 is selectively peeled off from the first adhesive layer 1 at the interface therebetween having the smallest adhesive strength among these three interfaces.

Further, in the case where the chip 83 is picked up, the chip 83 to be picked up may be selectively pushed up from a lower side of the film for semiconductor 10. In this case, since the chip 83 is pushed up within the laminated body 8, it becomes possible to further easily perform the pickup of the chip 83. In this regard, in order to push up the chip 83, used is a needle for pushing up the film for semiconductor 10 from the lower side thereof or the like. Namely, the die bonder 250 may include such a needle.

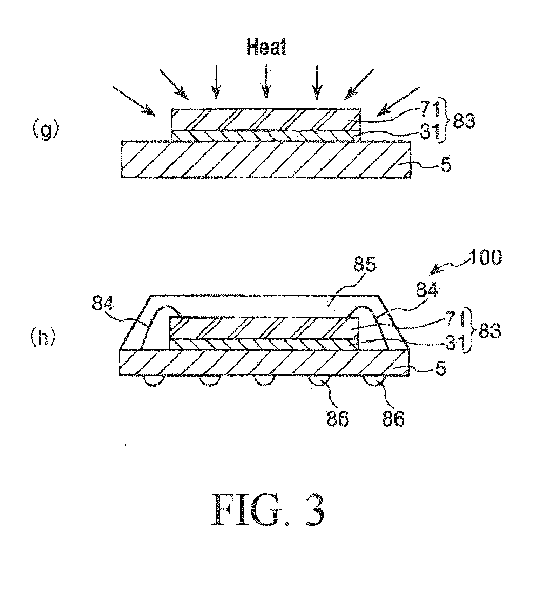

[4-2] Next, as shown in FIG. 3(g), the chip 83 mounted on the insulating substrate 5 is heated and pressed. In this way, the semiconductor element 71 and the insulating substrate 5 are bonded (die bonded) together through the diced bonding layer 31 (that is, this step is the fourth step).

As for conditions of the heat and press, for example, a heat temperature is preferably in the range of about 100 to 300°C, and more preferably in the range of about 100 to 200°C. Further, a press time is preferably in the range of about 1 to 10 seconds, and more preferably in the range of about 1 to 5 seconds.

After being heated and pressed, a heat treatment may be carried out. In this case, heat conditions are set to a heat temperature of preferably about 100 to 300°C and more preferably about 150 to 250°C, and a heat time of preferably about 1 to 240 minutes and more preferably about 10 to 60 minutes.

Thereafter, terminals of the semiconductor element 71 (not shown in the drawings) and terminals of the insulating substrate 5 (not shown in the drawings) are electrically connected together through wires 84. In this regard, it is to be noted that this connection may be carried out using a conductive paste, a conductive film or the like instead of the wires 84.

Then, the chip 83 mounted on the insulating substrate 5 and the wires 84 are sealed by a resin material, to thereby form a mold layer 85. Examples of the resin material constituting the mold layer 85 include various kinds of mold resins such as an epoxy-based resin.

Further, ball-shaped electrodes are bonded to terminals provided on a lower surface of the insulating substrate 5 (not shown in the drawings). In this way, it is possible to obtain a semiconductor device 100 shown in FIG. 3(h) in which the semiconductor element 71 is placed in a package.

According to the above method, since the semiconductor element 71 is picked up in the state that the diced bonding layer 31 is attached thereto so as to form the chip 83 during the third step, the diced bonding layer 31 can be directly used for bonding the semiconductor element 71 to the insulating substrate 5 during the fourth step. Therefore, a bonding agent or the like does not need to be separately prepared, which makes it possible to further improve efficiency for manufacturing the semiconductor devices 100.

Meanwhile, by repeating the process, in which the chip 83 is picked up using the die bonder 250, and then pressed onto the insulating substrate 5, heat from the heater 270 is transferred to the collet 260 through the chip 83, and accumulated thereto little by little. In this way, since the collet 260 becomes hot, the pickup step is carried out at a high temperature in consequence of the heat, although this step is assumed to be carried out at a normal temperature under ordinary circumstances.
At this time, a temperature of the collet 260 becoming hot, generally, rises up to a temperature of 60°C or more depending on the heat of the heater 270.

In the case where the temperature of the collet 260 rises, there is a fear that the heat from the collet 260 is also transferred to the laminated body 8 when the chip 83 is picked up, which causes involuntary increase of the bonding property of the bonding layer 3 included in the laminated body 8. In this state, the chips 83, which have been once separated form each other by the dicing, are re-bonded (attached) together due to the increase of the bonding property or viscosity decrease of the bonding layer 3, or the adhesive strength of the interface between the bonding layer 3 and the first adhesive, layer 1, which are peeled off from each other when the chip 83 is picked up, is enhanced. This is likely to cause a problem in that smooth pickup of the chip 83 becomes difficult.

In order to solve such a problem, the present inventors earnestly have examined on a film for semiconductor which can carry out the smooth pickup of the chip 83 even in the case where the temperature of the laminated body 8 involuntarily rises. As a result, in order to achieve the above object, the inventors have found that optimization of adhesive strength of the chip 83 so as to fall within the following range is effective and completed the present invention.

Namely, as described above, the film for semiconductor 10 (that is, the film for semiconductor of the present invention) is **characterized in that** in the case where the adhesive strength at 23°C of the first adhesive layer 1 with respect to the bonding layer 3 is defined as "F₂₃ (cN/25mm)" and the adhesive strength at 60°C of the first adhesive layer 1 with respect to the bonding layer 3 is defined as "F₆₀ (cN/25mm)", F₂₃ is in the range of 10 to 80 and F₆₀/F₂₃ is in the range of 0.3 to 5.5.

According to such a film for semiconductor 10, not only under a normal temperature but also even in the case where the temperature of the laminated body 8 rises in association with the temperature rise of the collet 260, it is possible to smoothly carry out the pickup of the chip 83. This makes it possible to reliably suppress generation of the defects such as the breakage and the crack in the semiconductor element 71 (that is, the pickup defects). Namely, it is possible to manufacture semiconductor devices 100 each having a good reliability in a high yield ratio.

Further, if F₂₃ exceeds the above upper limit value, it is hardly to carry out the smooth pickup of the chip 83 at the normal temperature. On the other hand, if F₂₃ is less than the above lower limit value, the adhesive strength of the interface between the bonding layer 3 and the first adhesive layer 1 included in the laminated body 8 is remarkably lowered, which causes dicing defects due to occurrence of peel off at this interface when the laminated body 8 is diced.

Furthermore, if F₆₀/F₂₃ exceeds the above upper limit value, since the ratio of F₆₀ (cN/25mm) to F₂₃ (cN/25mm) becomes too large, although it is possible to smoothly pick up the chip 83 at the normal temperature, the pickup property of the chip 83 is lowered at the high temperature. On the other hand, if F₆₀/F₂₃ is less than the above lower limit value, since the ratio of F₆₀ (cN/25mm) to F₂₃ (cN/25mm) becomes too small, although it is possible to smoothly pick up the chip 83 at the normal temperature, some chips 83 other than the chip 83 adsorbed by the collect 260 are also peeled off from the first adhesive layer 1. In this case, the peeled off chips 83 disturb subsequent pickup of the chip 83.
In this regard, it is to be noted that F₂₃ and F₆₀ are measured in detail as follows, respectively.

A sample (laminated film) in which the bonding layer 3 has attached to a surface of the first adhesive layer 1 is formed into a strip shape having a width of 25 mm, and then a portion corresponding to the bonding layer 3 is removed from the sample at a peel off angle of 180° and a pull speed of 1,000 mm/min and at 23°C (room temperature). At this time, a magnitude of a tensile load (unit: cN) imparted (applied) to the portion is measured while removing it. Namely, F₂₃ and F₆₀ are 180° peel strength of the first adhesive layer 1 with respect to the bonding layer 3 at 23°C and 60 °C, respectively.

Further, as described above, F₂₃ is in the range of 10 to 80, but is preferably in the range of about 20 to 70, and more preferably in the range of about 30 to 60.

Furthermore, as described above, F₆₀/F₂₃ is in the range of 0.3 to 5.5, but is preferably in the range of about 0.8 to 5, and more preferably in the range of about 1 to 4.

In this regard, it is to be noted that a range of F₆₀ is defined based on a relative relation to F₂₃, but a concrete range of F₆₀ is preferably the same as that of F₂₃.

Further, from the viewpoint of reliably exhibiting the above mentioned property (most appropriate adhesive property), a constituent material of the bonding layer 3 contains a thermosetting resin including a compound having a softening point of 70 to 130°C of which amount is preferably in the range of 60 to 100 wt% and more preferably in the range of 80 to 95 wt%.
This makes it possible to prevent the bonding property of the bonding layer 3 from remarkably rising with a change from the normal temperature to the high temperature. As a result, even if the collet 260 becomes hot, it is possible to carry out the smooth pickup of the chip 83 in the same manner as at the normal temperature. Namely, it is possible to improve the pickup property of the chip 83.

Further, there is a fear that F₆₀/F₂₃ increases as the temperature rises so that the pickup property of the chip 83 is lowered. However, by setting the ratio of the compound having the softening point of 70 to 100°C to a value falling within the above range, an increase rate of F₆₀/F₂₃ is suppressed. This makes it possible to adjust a value of F₆₀/F₂₃ so as to fall within the above range. Namely, this makes it possible to smoothly carry out the pickup of the chip 83 regardless of the temperature.

Examples of the compound having the softening point of 70 to 110°C include: an epoxy-based resin such as bisphenol A epoxy resin, bisphenol F epoxy resin (e.g., "YSLV80XY" produced by Nippon Steel Chemical Co., Ltd.), biphenyl-type epoxy resin (e.g., "YX4000K" produced by Japan Epoxy Resin Corporation), cresol novolac-type epoxy resin (e.g., "EOCN-1020-80" produced by Nippon Kayaku Co., Ltd., "N-673", "N-680" and "N-685-EXP-S" each produced by DIC Corporation) or naphthalene-type epoxy resin (e.g., "HP-4700" produced by DIC Corporation); a phenoxy resin; and the like. One of them or a mixture containing two or more of them can be used.

Further, from the same viewpoint, it is preferred that the thermosetting resin of the constituent material of the bonding layer 3 includes a compound having a softening point of 30°C or more but less than 70°C of which amount is in the range of 40 wt% or less. This makes it possible to prevent lowering of the pickup property of the chip 83 and to prevent the wafer ring 9 from being separated from the laminated body 8 when being diced due to optimization of the adhesive strength between the bonding layer 3 and the first adhesive layer 1.
Namely, the adhesive strength between the bonding layer 3 and the first adhesive layer 1 becomes necessary and sufficient when the laminated body 8 is diced, to thereby improve the dicing property thereof. In this regard, it is to be noted that a lower limit value of an amount of the compound having the softening point of 30°C or more but less than 70°C included in the thermosetting resin is not limited to a specific value, but is, for example, set to 1 wt%.

Examples of the compound having the softening point of 30°C or more but less than 70°C include: an epoxy-based resin such as bisphenol A epoxy resin (e.g., "YL6810" produced by Japan Epoxy Resin Corporation, bisphenol F epoxy resin, biphenyl-type epoxy resin or novolac epoxy resin; a phenoxy resin; and the like.

Furthermore, the softening point of the resin material can be adjusted by changing a molecular weight thereof, flexibility of a chemical structure thereof, the kind of a functional group contained therein and the like. By doing so, even if the resin material is the same kind, the softening point thereof can be made 70°C or more or less than 70°C.
For example, if the molecular weight of the resin material is made large, the softening point thereof can be made high.

Moreover, the property of the bonding layer 3 is identified by not only the softening point of the resin material but also an ICI viscosity of the resin material.
The thermosetting resin of the constituent material of the bonding layer 3 includes a compound having an ICI viscosity at 150°C of 1 to 20 dPa·s of which amount is preferably in the range of 60 to 100 wt% and more preferably in the range of 80 to 95 wt%. This makes it possible to prevent the bonding property of the bonding layer 3 from remarkably rising especially at the high temperature. As a result, even if the collet 260 becomes hot, it is possible to carry out the smooth pickup of the chip 83 in the same manner as at the normal temperature. Namely, it is possible to improve the pickup property of the chip 83 at the high temperature.

In addition, it is preferred that a melt viscosity at 60°C of the constituent material of the bonding layer 3 is in the range of 1 × 10² to 1 × 10⁵ Pa·s. By setting the melt viscosity at 60°C of the constituent material of the bonding layer 3 to a value falling within the above range, even in the case where the bonding layer 3 is melt, a viscosity of a molten material thereof becomes high. This make it possible to further suppress the bonding property of the bonding layer 3 at the high temperature.

According to the above mentioned film for semiconductor 10, even in the case where the temperature of the laminated body 8 rises in association with the temperature rise of the collet 260 of the die bonder 25, it is possible to suppress the bonding property of the bonding layer 3 from remarkably increasing, to thereby prevent lowering of the pickup property of the chip 83.

Meanwhile, the method for manufacturing a semiconductor device according to the present invention, which includes the step of dicing the film, for semiconductor 7 using the above mentioned film for semiconductor 10, is especially characterized by the second step.

First, a conventional dicing step will be described prior to description of such a characteristic.
The conventional dicing step is carried out so that the edge of the dicing blade comes down to the support film through the semiconductor wafer, the bonding layer and the respective adhesive layers.

However, in the case where the edge of the dicing blade comes down to the support film, the base film is shaved so that shavings thereof are produced. The shavings move in the vicinity of each adhesive bonding layer, in the vicinity of the bonding layer or in the vicinity of the semiconductor element without staying in the vicinity of the support film. This causes various defects.
Specifically, examples of the defects include disturbance in wire bonding, which would occur by being stuck in the semiconductor elements during the pickup, being penetrated into between the insulating substrate and the semiconductor element during a fourth step described below or adhering to the circuits each formed on the semiconductor wafer.

In contrast, in the present invention, a shaving depth is set so that the edge of the dicing blade 82 is located within the adhesive layer during the second step. In other words, the dicing is carried out so that the distal ends of the cutting lines 81 do not come down to the support film 4 and are located within the first adhesive layer 1. By carrying out the dicing in such a way, the shavings of the support film 4 are hardly to be produced. Therefore, it becomes possible reliably to dissolve the above mentioned problem attendant upon the shavings.
Namely, it is possible to prevent the occurrence of sticking to the semiconductor elements 71 or the like when being picked up, and to prevent the penetration of the shavings between the semiconductor element 71 and the insulating substrate 5 and the occurrence of the wire bonding defect when the semiconductor element 71 is mounted onto the insulating substrate 5. As a result, it is possible to improve a yield ratio of manufacturing semiconductor devices 100 and to obtain semiconductor devices 100 each having high reliability.

Further, in the case where the cutting lines 81 are formed so that the distal ends thereof are located within the first adhesive layer 1, it is possible to prevent ingredients contained in the second adhesive layer 2 from being exuded in the vicinity of the bonding layer 3 or in the vicinity of the semiconductor wafer 7 through the cutting lines 81.
As a result, it is possible to prevent defects such as disturbance of the pickup of the chip 83 which would occur due to involuntary enhancement of the adhesive strength between the bonding layer 3 and the first adhesive layer 1 by the exuded ingredients. Further, it is also possible to prevent alteration and deterioration of the semiconductor element 71 which would be caused by the exuded ingredients.

Since the adhesive property of the second adhesive layer 2 is higher than the adhesive property of the first adhesive layer 1 as described above, it is conceived that the second adhesive layer 2 necessarily has plasticity higher than that of the first adhesive layer 1. Therefor, fluidity and flowability of the ingredients contained in the second adhesive layer 2 are higher than those in the first adhesive layer 1, which is considered as a cause of the exudation of such ingredients.
Namely, in the case where a plurality of adhesive layers are provided like this embodiment and an adhesive property of an adhesive layer positioned at a side of the support film 4 (that is, the second adhesive layer 2 in FIG. 1) is higher than an adhesive property of an adhesive layer positioned at a side of the bonding layer 3 (that is, the first adhesive layer 1 in FIG. 1), it is especially effective that the distal ends of the cutting lines 81 are located within the first adhesive layer 1 as shown in FIG. 1(c) in order to prevent the above defects.

In this regard, from the above viewpoint, it is preferred that hardness of the second adhesive layer 2 is smaller than hardness of the first adhesive layer 1. This makes it possible to reliably impart a higher adhesive property to the second adhesive layer 2 as compared with the first adhesive layer 1. On the other hand, this also makes it possible for the first adhesive layer 1 to exhibit an excellent pickup property.

Further, Shore D hardness of the first adhesive layer 1 is preferably in the range of about 20 to 60, and more preferably in the range of about 30 to 50. Since in such a first adhesive layer 1 having the above hardness, fluidity and flowability of ingredients contained therein can be relatively lowered while appropriately suppressing the adhesive property thereof, even in the case where the cutting lines 81 are formed into the first adhesive layer 1, the first adhesive layer 1 can exhibit both the effect of improving the pickup property and the effect of preventing the defects which would be generated due to exudation of the ingredients from the first adhesive layer 1.

Furthermore, Shore A hardness of the second adhesive layer 2 is preferably in the range of about 20 to 90, and more preferably in the range of about 30 to 80. Since in such a second adhesive layer 2 having the above hardness, fluidity and flowability of ingredients contained therein can be relatively lowered while having a sufficient adhesive property thereof, the second adhesive layer 2 can exhibit both the effect of improving the dicing property (e.g., stability between the laminated body 8 and the wafer ring 9 during the dicing step) and the effect of preventing the defects which would be generated due to exudation of the ingredients from the second adhesive layer 2.

Moreover, from the above viewpoint, a cross sectional area of a distal end portion of one cutting line 81, which extends beyond the interface between the bonding layer 3 and the first adhesive layer 1, is preferably in the range of about 5×10⁻⁵ to 300×10⁻⁵ mm², and more preferably in the range of about 10×10⁻⁵ to 200×10⁻⁵ mm², but is varied depending on a thickness of the dicing blade 82 and/or the thickness of each of the first and second adhesive layers 1, 2.
By setting the cross sectional area of the distal end portion of the cutting line 81, which extends beyond the interface between the bonding layer 3 and the first adhesive layer 1, to a value falling within the above range, it is possible to reliably dice the bonding layer 3 and to minimize a cross sectional area of a portion of the cutting line 81 located within the first adhesive layer 1. As a result, it is possible to carry out reliable pickup of the chip 83 and to suppress the exudation of the ingredients from the first adhesive layer 1 in good balance.

Further, in the case where the thickness of the first adhesive layer 1 is defined as "t", a depth (length) of the portion of the cutting line 81 located within the first adhesive layer 1 is preferably in the range of 0.2t to 0.8t, and more preferably in the range of 0.3t to 0.7t. This makes it possible to carry out the reliable pickup of the chip 83 and to suppress the exudation of the ingredients from the first adhesive layer 1 in more good balance.

As described above, in the case where the distal ends of the cutting lines 81 are located within the first adhesive layer 1 or in the case where the cross sectional area of the distal end portion of each cutting line 81, which extends beyond the interface between the bonding layer 3 and the first adhesive layer 1, is set to a value falling within the above range, it is possible to minimize the exudation of the ingredients from the first adhesive layer 1 and the second adhesive layer 2.
This makes it possible to minimize the effect on the adhesive strength between the bonding layer 3 and the first adhesive layer 1 by the exuded ingredients. As a result, it is possible to prevent the disturbance of the pickup of the chip 83 which would occur due to involuntary enhancement of the above adhesive strength.

Specifically, by controlling the depth, the cross sectional area or the like of each cutting line 81, the adhesive strength between the first adhesive layer 1 and the bonding layer 3 (F₂₃, F₄₀ and F₆₀ as described above) is reliably fitted into the above mentioned value range. This makes it possible to further improve the pickup property of the chip 83, to thereby prevent generation of the defects such as the breakage, the crack and burr in the semiconductor element 71 when being picked up. As a result, it is possible to finally manufacture semiconductor devices 100 each having a good reliability in a high yield ratio.

Especially, in the case of a semiconductor wafer 7 having a thin thickness (e.g., 200 µm or less), by setting the adhesive strength between the first adhesive layer 1 and the bonding layer 3 to a value falling within the above range, the effect of preventing the above defects which would be generated in the semiconductor element 71 becomes remarkable.

Further, the adhesive strength between the first adhesive layer 1 and the bonding layer 3 of a central portion of each chip 83 is often different from that of an edge portion of each chip 83. This is because at the edge portion of the chip 83, ingredients contained in the first adhesive layer 1, for example, creep up along an end surface of the chip 83 so that the adhesive strength thereof tends to become larger than the adhesive strength of the central portion. For this reason, there is a fear that the large difference between the adhesive strength of the central portion and the adhesive strength of the edge portion causes the breakage and the crack in the semiconductor element 71 when the chip 83 is picked up.

On the other hand, according to the present invention, by controlling a dicing depth so that the distal ends of the cutting lines 81 are located within the first adhesive layer 1, it is possible to fit the adhesive strength difference between the respective portions of the chip 83 into a narrow range. This makes it possible to minimize generation of the breakage, the crack and the like in the semiconductor element 71 when being picked up.

Meanwhile, in the case where a load which is applied to the edge portion of the chip 83 (that is, the adhesive strength of the edge portion) is defined as "a" and a load which is applied to the central portion of the chip 83 (that is, the adhesive strength of the central portion) is defined as "b" when the chip 83 is peeled off from the first adhesive layer 1, a/b is preferably in the range of 1 to 4, more preferably in the range of about 1 to 3, and even more preferably in the range of about 1 to 2.
This makes it possible to suppress variation of loads at every portions of the semiconductor element 71 in a relatively narrow range. Therefore, it is possible to reliably suppress generation of the defects such as the breakage and the crack in the semiconductor element 71. Use of the film for semiconductor 10 makes it possible to improve a yield ratio of manufacturing semiconductor devices 100 and to finally obtain semiconductor devices 100 each having high reliability.

In this regard, it is to be noted that the adhesive strength "a" and the adhesive strength "b" are measured in detail as follows, respectively.
First, the semiconductor wafer 7 is laminated onto the film for semiconductor 10 to obtain the laminated body 8, and then the semiconductor wafer 7 is diced into 10 mm × 10 mm square. In this state, a strip adhesive film having a width of 1 cm adheres to an upper surface of the laminated body 8 which has not been applied to the third step yet at 23°C (room temperature).

Next, the first adhesive layer 1, the second adhesive layer 2 and the support film 4 are removed (peeled off) from the laminated body 8 at a peel off angle of 90° and a pull speed of 50 mm/min, and at 23°C (room temperature). At this time, a magnitude of a tensile load (unit: N), to which each of the first adhesive layer 1, the second adhesive layer 2 and the support film 4 is imparted, is measured while peeling off the first adhesive layer 1, the second adhesive layer 2 and the support film 4.
An average value of the tensile loads, to which the first adhesive layer 1, the second adhesive layer 2 and the support film 4 are imparted when an edge portion of the chip 83 is peeled off from the first adhesive layer 1, corresponds to the "adhesive strength "a"". On the other hand, an average value of the tensile loads, to which the first adhesive layer 1, the second adhesive layer 2 and the support film 4 are imparted, when an central portion (other than the edge portion) of the chip 83 is peeled off from the first adhesive layer 1 corresponds to the "adhesive strength "b"".

Namely, according to the film for semiconductor 10, even in the case of either the state that the edge portion of the chip 83 is about to be separated from the first adhesive layer 1 or the state that the central portion of the chip 83 is about to be separated from the first adhesive layer 1, it is possible to set a difference between the magnitudes of the tensile loads, to which the first adhesive layer 1, the second adhesive layer 2 and the support film 4 are imparted, within a relatively small range.
Therefore, even if warp of the semiconductor element 71 occurs, a degree of the warp is minimized. As a result, it is possible to minimize the defects such as the breakage and the crack in the semiconductor element 71.

Furthermore, it is preferred that the adhesive strength "b" of the central portion (other than the edge portion) of the chip 83 falls within the range of the adhesive strength between the first adhesive layer 1 and the bonding layer 3.

Especially, in the case of a semiconductor wafer 7 having a thin thickness (e.g., 200 µm or less), by setting the adhesive strength "b" to a value falling within the above range, the effect of preventing the above defects which would be generated in the semiconductor element 71 becomes remarkable.

In this regard, the edge portion of the chip 83 is defined as a portion extending up to 10% of a width of the semiconductor element 71 from an outer edge of the semiconductor element 71. On the other hand, the central portion of the chip 83 is defined as a portion other than the edge portion. Namely, in the case where a shape of the semiconductor element 71 is a square having a size of 10 mm on a side at a plane view thereof, a portion having a width of 1 mm from an outer edge thereof is the edge portion and a residual portion is the central portion.

Further, in this embodiment, by locating the distal ends of the cutting lines 81 within the first adhesive layer 1, the semiconductor wafer 7 and the binding layer 3 are reliably diced, whereas the first adhesive layer 1 and the second adhesive layer 2 are not diced. This makes it possible to leave the first adhesive layer 1 and the second adhesive layer 2 intact on the support film 4 when the chip 83 is picked up during the third step so as to prevent the chip 83, to which the above adhesive layers adhere, from being involuntarily picked up.
This is because a successive state of each of the first adhesive layer 1 and the second adhesive layer 2 in a plane direction thereof is kept by not subjecting them to the dicing, which makes it possible to prevent the adhesive strength between the first adhesive layer 1 and the second adhesive layer 2 and the adhesive strength between the second adhesive layer 2 and the support film 4 from being reduced. Namely, this is because the adhesive strength between the first adhesive layer 1 and the second adhesive layer 2 and the adhesive strength between the second adhesive layer 2 and the support film 4 can sufficiently oppose to upward tensile strength to be generated when the chip 83 is picked up.

Furthermore, since the adhesive strength between the first adhesive layer 1 and the second adhesive layer 2 and the adhesive strength between the second adhesive layer 2 and the support film 4 are prevented from being reduced as described above, even in the case where the adhesive strength between the first adhesive layer 1 and the bonding layer 3 makes larger, it is possible to prevent the pickup property of the chip 83 from being lowered.
Namely, since an allowable margin of the adhesive strength between the first adhesive layer 1 and the bonding layer 3, which is able to appropriately pick up the chip 83, can be widened, there is also a merit in that ease for manufacturing the film for semiconductor 10 and the bonding property between the mounted semiconductor element 71 and the insulating substrate 5 are improved.

### <Second Embodiment>

Next, description will be made on a second embodiment of the film for semiconductor of the present invention and the method for manufacturing a semiconductor device of the present invention.

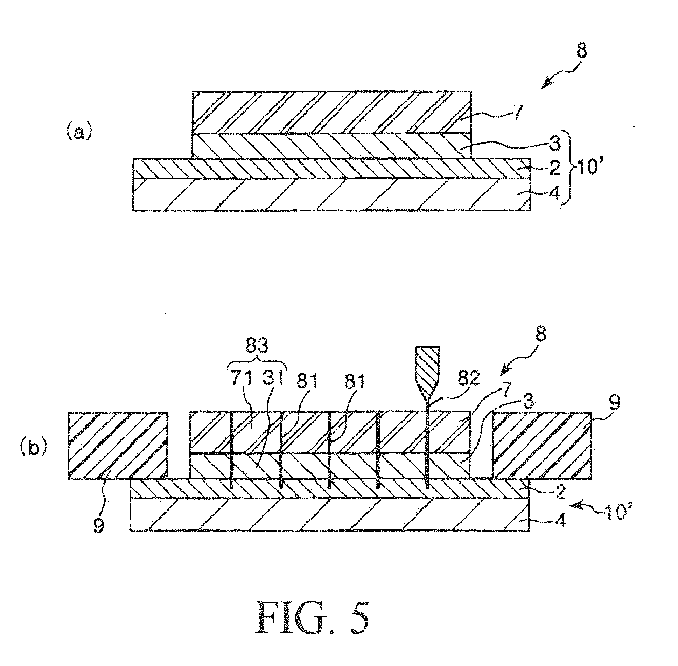

FIG. 5 is a view (sectional view) for explaining the second embodiment of the film for semiconductor of the present invention and the method for manufacturing a semiconductor device of the present invention. In this regard, in the following description, the upper side in FIG. 5 will be referred to as "upper" and the lower side thereof will be referred to as "lower".

Hereinbelow, the second embodiment will be described with emphasis placed on points differing from the first embodiment. No description will be made on the same points. In this regard, it is to be noted that the same reference numbers earlier described in FIG. 1 are applied to the same components shown in FIG. 5 as those of the first embodiment.

A film for semiconductor 10' according to this embodiment is the same as the first embodiment except that the layer structure of the adhesive layer is different therefrom.

Namely, in the film for semiconductor 10' shown in FIG. 5, the first adhesive layer 1 is omitted, and only one layer formed from the second adhesive layer 2 is provided.

In the case where such a film for semiconductor 10' is produced, a region of an upper surface of the second adhesive layer 2 to be made contact with the bonding layer 3 (that is, a region above which the semiconductor wafer 7 is to be laminated) is, in advance, irradiated with an ultraviolet ray. In this way, an adhesive property of this region is deactivated, which makes it possible to reduce adhesive strength between the second adhesive layer 2 and the bonding layer 3. As a result, when the chip 83 is picked up during the third step, the chip 83 can be picked up without applying a large load thereto. In other words, it is possible to further improve the pickup property of the chip 83.

On the other hand, since a region of the upper surface of the second adhesive layers 2 to be not made contact with the bonding layer 3 is not irradiated with the ultraviolet ray, original adhesive strength of the second adhesive layer 2 is maintained in this region. Therefore, the adhesive strength between the second adhesive layer 2 and the wafer ring 9 is also maintained, which prevents the dicing property of the film for semiconductor 10' from being lowered.

In other words, the first embodiment can combine the dicing property and the pickup property by utilizing the two adhesive layer having different adhesive properties. On the other hand, this embodiment can combine the dicing property and the pickup property in spite of the use of the single adhesive layer by lowering the adhesive property of only a part of the second adhesive layer 2.

Onto such a film for semiconductor 10' , as shown in FIG. 5(a), a semiconductor wafer 7 is laminated, to thereby obtain a laminated body 8.

Next, as shown in FIG. 5 (b), a plurality of cutting lines 81 are formed into the laminated body 8 using the dicing blade 82 (that is, dicing is carried out). At this time, as shown in FIG. 5(b), by carrying out the dicing so that the distal ends of the cutting lines 81 are located within the second adhesive layer 2, the shavings of the support film 4 are hardly to be produced. For this reason, it is possible to obtain the same actions and effects as the first embodiment.
Thereafter, the third step and the fourth step are carried out. In this way, it is possible to obtain a semiconductor device.

In this regard, a wavelength of the ultraviolet ray, with which the second adhesive layer 2 is irradiated, is preferably in the range of about 100 to 400 nm, and more preferably in the range of about 200 to 380 nm. Further, an irradiation time of the ultraviolet ray is preferably in the range of about 10 seconds to 1 hour, and more preferably in the range of about 30 seconds to 30 minutes depending on the wavelength or power thereof.
By using such an ultraviolet ray, it is possible to effectively deactivate the adhesive property of the second adhesive layer 2 and to prevent excessive lowering of the adhesive property thereof due to change of chemical structures in the second adhesive layer 2.

Further, the second adhesive layer 2 may be irradiated with various kinds of radioactive rays such as an electron ray and an X-ray instead of the ultraviolet ray.

In this regard, the region of the upper surface of the second adhesive layer 2 to be made contact with the bonding layer 3 may be not irradiated with the ultraviolet ray like this embodiment. For example, in the case where a constitute material of the second adhesive layer 2 is cured by being sensitized with the ultraviolet ray, the second adhesive layer 2 may be irradiated with the ultraviolet ray either after the bonding layer 3 is laminated thereon, after the bonding layer 3 and the semiconductor wafer 7 are laminated thereon or after the bonding layer 3 and the semiconductor wafer 7 are laminated thereon and then the semiconductor wafer 7 is diced.
In such cases, since the second adhesive layer 2 is cured due to the irradiation of the ultraviolet ray, an adhesive property of a region of the second adhesive layer 2 where is irradiated with the ultraviolet ray is lowered. As a result, even in these cases, it is possible to improve the pickup property of the chip 83.

While the descriptions are made on the film for semiconductor and the method for manufacturing a semiconductor device according to the present invention based on the embodiments shown in the drawings, the present invention is not limited thereto.

Examples of a type of the package include, but are not limited to, a surface mount-type package such as CSP (Chip Size Package) (e.g., BGA (Ball Grid Array), LGA (Land Grid Array)) or TCP (Tape Carrier Package), an insertion-type package such as DIP (Dual Inline Package) or PGA (Pin Grid Array), and the like.

Further, in the description of each embodiment, the chip 83 is mounted on the insulating substrate 5, but may be mounted on another chip. Namely, the method for manufacturing a semiconductor device according to the present invention is used for manufacturing a chip stack-type semiconductor device in which a plurality of semiconductor elements are laminated together. This makes it possible to omit a fear that pickup is not carried out appropriately or a fear that shavings or the like penetrate into a space between the semiconductor elements, to thereby manufacture a chip stack-type semiconductor device having high reliability in a high yield ratio.

Furthermore, in the first embodiment, the cutting lines 81 are formed so that the distal ends thereof are located within the first adhesive layer 1. However, even in the case where the cutting lines 81 are formed so that the distal ends thereof are located within the second adhesive layer 2, it is possible to obtain the same actions and effects as the second embodiment, but the effect of suppressing the exudation of the ingredients is lowered.

Moreover, arbitrary steps also may be added to the method for manufacturing a semiconductor device according to the present invention, if needed.

### Examples

Hereinbelow, concrete examples of the present invention will be described.

### 1. Manufacture of Semiconductor Device

### (Example 1)

### <1> Formation of First Adhesive Layer

100 parts by weight of a copolymer having a weight average molecular weight of 300,000 which was obtained by polymerizing 30 wt% of 2-ethyl hexyl acrylate with 70 wt% of vinyl acetate, 45 parts by weight of a penta-functional acrylate monomer having a molecular weight of 700, 5 parts by weight of 2,2-dimethoxy-2-phenyl acetophenone and 3 parts by weight of tolylene diisocyanate ("CORONATE T-100" produced by NIPPON POLYURETHANE INDUSTRY CORPORATION) were applied onto a polyester film having a thickness of 38 µm and subjected to a releasing treatment so that a thickness thereof after being dried would become 10 µm, and then dried at 80°C for 5 minutes to obtain an application film. Thereafter, the obtained application film was irradiated with an ultraviolet ray having 500 mJ/cm² to thereby form a first adhesive layer on the polyester film.
In this regard, it is to be noted that Shore D hardness of the obtained first adhesive layer was 40.

### <2> Formation of Second Adhesive Layer

100 parts by weight of a copolymer having a weight average molecular weight of 500,000 which was obtained by polymerizing 70 wt% of butyl acrylate with 30 wt% of 2-ethyl hexyl acrylate, 3 parts by weight of tolylene diisocyanate ("CORONATE T-100" produced by NIPPON POLYURETHANE INDUSTRY CORPORATION) were applied onto a polyester film having a thickness of 38 µm and subjected to a releasing treatment so that a thickness thereof after being dried would become 10 µm, and then dried at 80°C for 5 minutes. In this way, a second adhesive layer was formed on the polyester film. Thereafter, a polyethylene sheet having a thickness of 100 µm was laminated onto the second adhesive layer as a support film.
In this regard, it is to be noted that Shore A hardness of the obtained second adhesive layer was 80.

### <3> Formation of Bonding Layer

100 parts by weight of an acrylate copolymer having a weight average molecular weight of 500,000 and Tg of 6°C (a solid content contained in methyl ethyl ketone (MEK) dissolving an ethyl acrylate-butyl acrylate-acrylonitrile-acrylic acid-hydroxyethyl methacrylate copolymer "SG-708-6" produced by Nagase ChemteX Corporation), 261 parts by weight of epoxy resin having a softening point of 80°C and an ICI viscosity at 25°C of 5.2 dpa-s ("EOCN-1020-80" produced by Nippon Kayaku Co., Ltd.), 56 parts by weight of spherical silica having an average particle size of 0.5 µm ("SE2050-LC" produced by Admatechs) as a filler, 0.5 parts by weight of Y-glycidoxypropyl trimethoxysilane ("KBM403E" produced by Shin-Etsu Chemical Corporation) as a coupling agent, 55 parts by weight of phenol resin having a hydroxyl equivalent of 104 g/OH group ("PR-HF-3" produced by Sumitomo Bakelite Co. Ltd.), 82 parts by weight of another phenol resin having a hydroxyl equivalent of 141 g/OH group ("MEH8000H" produced by MEIWA ELASTIC INDUSTRIES, LTD.) and 0.8 parts by weight of an imidazole compound ("2PHZ-PW" produced by Shikoku Chemicals Corporation) as an accelerator were dissolved into methyl ethyl ketone, to thereby obtain a resin varnish having a resin solid content of 45 wt%.

Next, the obtained resin varnish was applied onto a polyethylene terephthalate film having a thickness of 38 µm (Product Number "Purex A43" produced by Teijin DuPont Films Japan Limited) using a comma coater, and then dried at 130°C for 3 minutes, to thereby obtain a bonding layer having a thickness of 25 µm on the polyethylene terephthalate film.

In this regard, it is to be noted that a melt viscosity at 60°C of the obtained resin varnish was 5 x 10² Pa's.

### <4> Production of Film for Semiconductor

The film on which the first adhesive layer was formed was laminated onto the film on which the bonding layer was formed so that the first adhesive layer made contact with the bonding layer, and then the polyester film attaching to the first adhesive layer was peeled off therefrom, to thereby obtain a laminated body.

Next, the first adhesive layer and the bonding layer were punched out so as to have sizes larger than an outer diameter of a semiconductor wafer and smaller than an inner diameter of a wafer ring, and then an unnecessary portion was removed, to thereby obtain a second laminated body.

Further, the polyester film attaching to one surface of the second adhesive layer was peeled off therefrom. Thereafter, the second laminated body was laminated thereonto so that the first adhesive layer made contact with the second adhesive layer. In this way, obtained was a film for semiconductor in which the polyethylene sheet (support film), the second adhesive layer, the first adhesive layer, the bonding layer and the polyester film were laminated together in this order.

### <5> Manufacture of Semiconductor Device

Next, prepared was a silicon wafer having a thickness of 100 µm and a size of 8 inches.

Next, the polyester film was removed from the film for semiconductor, and then a silicon wafer was laminated onto an exposed surface thereof at 60°C. In this way, obtained was a laminated body in which the polyethylene sheet (support film), the second adhesive layer, the first adhesive layer, the bonding layer and the silicon wafer were laminated together in this order.

Next, this laminated boy was diced (segmented) from a side of the silicon wafer using a dicing saw ("DFD6360" produced by DISCO Corporation) under the following conditions. In this way, the silicon wafer was diced, to thereby obtain semiconductor elements each having the following dicing size.

<Dicing Conditions>
·Dicing Size: 10 mm × 10 mm square
·Dicing Speed: 50 mm/sec
·Speed of Rotation of Spindle: 40,000 rpm
·Dicing Maximum Depth: 0.130 mm (Cutting Amount from Surface of Silicon Wafer)
·Thickness of Dicing Blade: 15 µm
·Cross Sectional Area of Cutting Line: 7.5·10⁻⁵ mm² (Cross Sectional Area of Distal End Portion Extending beyond Interface between Bonding Layer and First Adhesive Layer)

In this regard, it is to be noted that distal ends of cutting lines formed by being diced were located within the first adhesive layer.

Meanwhile, in order to estimate a pickup property of the semiconductor element, 180° peel strength (adhesive strength) between the bonding layer and the first adhesive layer was measured. This peel strength was defined as a load which was measured when the film for semiconductor was formed into a strip shape having a width of 25 mm, and then a portion corresponding to the bonding layer 3 was removed from the film for semiconductor at a peel off angle of 180° and a pull speed of 1,000 mm/min and at 23°C (room temperature). In this regard, it is to be noted that the peel off occurred at an interface between the first adhesive layer and the bonding layer in the film for semiconductor.
As a result of this measurement, the peel strength at 23°C (F₂₃) thereof was 25 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 41 cN/25mm and the peel strength at 60°C (F₆₀) thereof was 60 cN/25mm.
Further, a ratio of F₆₀ to F₂₃ (that is, F₆₀/F₂₃) was 2.4.

Thereafter, 100 chips were continuously picked up at each of die mount temperatures of 23°C and 130°C using a die bonder in order to be mounted onto a below mentioned bismaleimide triazine resin substrate coated with a solder resist (product name: "AUS308" produced by Taiyo Ink Mfg. Co., Ltd.) and having a circuit step of 5 to 10 µm ("AD898" produced by ASM corporation) In this way, it was judged that the pickup property of the semiconductor element was good or bad

As a result, all 100 semiconductor elements could be appropriately picked up under both die mount temperature conditions of 23°C and 130°C.

Next, the picked up chip was die bonded onto the above bismaleimide triazine resin substrate coated with a solder resist (product name: "AUS308" produced by Taiyo Ink Mfg. Co., Ltd.) and having a circuit step of 5 to 10 µm by being pressed at a temperature of 130°C and at a load of 5 N for 10 seconds. Thereafter, the same was subjected to a heat treatment for at a temperature of 120°C for 1 hour so that the bonding layer was semi-cured.

Thereafter, the semiconductor element and the resin substrate were electrically connected together by wire bonding.
The, the semiconductor element on the resin substrate and the bonding wires were sealed by a mold resin (EME-G760), and then subjected to a heat treatment at a temperature of 175°C for 2 hours. In this way, the mold resin was cured, to thereby obtain a semiconductor device. In this regard, it is to be noted that 100 semiconductor devices were manufactured in this Example.

### (Example 2)

Semiconductor devices were manufactured in the same manner as Example 1, except that 78 parts by weight of NC3000P (produced by Nippon Kayaku Co., Ltd.; a softening point of 57°C; an ICI viscosity at 150°C of 1.11 dPa-s) and 183 parts by weight of EOCN-1020-80 (produced by Nippon Kayaku Co., Ltd.; a softening point of 80°C; an ICI viscosity at 150°C of 5.2 dpa·s) were used as the epoxy resin contained in the bonding layer.

Here, on the film for semiconductor, the 180° peel strength (adhesive strength) between the bonding layer and the first adhesive, layer thereof was measured in the same manner as Example 1.
As a result of this measurement, the peel strength at 23°C (F₂₃) thereof was 25 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 42 cN/25mm and the peel strength at 60°C (F₆₀) thereof was 83 cN/25mm.
Further, a ratio of F₆₀ to F₂₃ (that is, F₆₀/F₂₃) was 3.3.

Thereafter, 100 chips were continuously picked up at each of the die mount temperatures of 23°C and 130°C using the die bonder in order to be mounted onto the above bismaleimide triazine resin substrate coated with the solder resist (product name: "AUS308" produced by Taiyo Ink Mfg, Co., Lid.) and having the circuit step of 5 to 10 µm ("AD898" produced by ASH corporation). In this way, it was judged that the pickup property of the semiconductor element was good or bad.

As a result, all 100 semiconductor elements could be appropriately picked up at the die mount temperature of 23°C. On the other hand, pickup defects occurred at the die mount temperature of 130°C in one semiconductor element.

### (Example 3)

Semiconductor devices were manufactured in the same manner as Example 1, except that 261 parts by weight of N-685-EXP-S (produced by DIC Corporation; a softening point of 85°C; an ICI viscosity at 150°C of 12.0 dPa·s) was used as the epoxy resin contained in the bonding layer.

Here, on the film for semiconductor, the 180° peel strength (adhesive strength) between the bonding layer and the first adhesive layer thereof was measured in the same manner as Example 1.
As a result of this measurement, the peel strength at 23°C (F₂₃) thereof was 32 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 28 cN/25mm and the peel strength at 60°C (F₆₀) thereof was 37 cN/25mm.
Further, a ratio of F₆₀ to F₂₃ (that is, F₆₀/F₂₃) was 1.2.

Thereafter, 100 chips were continuously picked up at each of the die mount temperatures of 23°C and 130 °C using the die bonder in order to be mounted onto the above bismaleimide triazine resin substrate coated with the solder resist (product name: "AUS308" produced by Taiyo Ink Mfg. Co., Ltd.) and having the circuit step of 5 to 10 µm ("AD898" produced by ASM corporation). In this way, it was judged that the pickup property of the semiconductor element was good or bad.

As a result, all 100 semiconductor elements could be appropriately picked up under both the die mount temperature conditions of 23°C and 130°C.

### (Example 4)

Semiconductor devices were manufactured in the same manner as Example 1, except that 261 parts by weight of YDCN-700-10 (produced by Tohto Kasei Co., Ltd.; a softening point of 80°C; an ICI viscosity at 150°C of 10.0 dPa·s) was used as the epoxy resin contained in the bonding layer.

Here, on the film for semiconductor, the 180° peel strength (adhesive strength) between the bonding layer and the first adhesive layer thereof was measured in the same manner as Example 1.
As a result of this measurement, the peel strength at 23°C (F₂₃) thereof was 35 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 45 cN/25mm and the peel strength at 60°C (F₆₀) thereof was 60 cN/25mm.
Further, a ratio of F₆₀ to F₂₃ (that is, F₆₀/F₂₃) was 2.1.

Thereafter, 100 chips were continuously picked up at each of the die mount temperatures of 23°C and 130°C using the die bonder in order to be mounted onto the above bismaleimide triazine resin substrate coated with the solder resist (product name: "AUS308" produced by Taiyo Ink Mfg. Co., Ltd.) and having the circuit step of 5 to 10 µm ("AD898" produced by ASM corporation). In this way, it was judged that the pickup property of the semiconductor element was good or bad.

As a result, all 100 semiconductor elements could be appropriately picked up under both the die mount temperature conditions of 23°C and 130°C.

### (Example 5)

Semiconductor devices were manufactured in the same manner as Example 1, except that 261 parts by weight of HP-4700 (produced by DIG Corporation; a softening point of 90°C; an ICI viscosity at 150°C of 4.5 dPa·s) was used as the epoxy resin contained in the bonding layer.

Here, on the film for semiconductor, the 180° peel strength) (adhesive strength) between the bonding layer and the first adhesive layer thereof was measured in the same manner as Example 1.
As a result of this measurement, the peel strength at 23°C (F₂₃) thereof was 50 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 55 cN/25mm and the peel strength at 60°C (F₆₀) thereof was 80 cN/25mm.
Further, a ratio of F₆₀ to F₂₃ (that is, F₆₀/F₂₃) was 1.6.

Thereafter, 100 chips were continuously picked up at each of the die mount temperatures of 23°C and 130°C using the die bonder in order to be mounted onto the above bismaleimide triazine resin substrate coated with the solder resist (product name: "AUS308" produced by Taiyo Ink Mfg. Co., Ltd.) and having the circuit step of 5 to 10 µm ("AD898" produced by ASM corporation). In this way, it was judged that the pickup property of the semiconductor element was good or bad.

As a result, all 100 semiconductor elements could be appropriately picked up under both the die mount temperature conditions of 23°C and 130°C.

### (Comparative Example 1)

Semiconductor devices were manufactured in the same manner as Example 1, except that 261 parts by weight of YL6810 (produced by Japan Epoxy Resin Corporation; a softening point of 45°C; an ICI viscosity at 150°C of 0.03 dPa·s) was used as the epoxy resin contained in the bonding layer.

Here, on the film for semiconductor, the 180° peel strength (adhesive strength) between the bonding layer and the first adhesive layer thereof was measured in the same manner as Example 1.
As a result of this measurement, the peel strength at 23°C (F₂₃) thereof was 112 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 134 cN/25mm and the peel strength at 60°C (F₆₀) thereof was 300 cN/25mm.
Further, a ratio of F₆₀ to F₂₃ (that is, F₆₀/F₂₃) was 2.7.

Thereafter, 100 chips were continuously picked up at each of the die mount temperatures of 23°C and 130 °C using the die bonder in order to be mounted onto the above bismaleimide triazine resin substrate coated with the solder resist (product name: "AUS308" produced by Taiyo Ink Mfg. Co., Ltd.) and having the circuit step of 5 to 10 µm ("AD898" produced by ASM corporation). In this way, it was judged that the pickup property of the semiconductor element was good or bad.

Asp a result, pickup defects occurred at the die mount temperature of 23°C in 60 semiconductor elements. On the other hand, pickup defects occurred at the die mount temperature of 130°C in all 100 semiconductor elements.

### (Comparative Example 2)

Semiconductor devices were manufactured in the same manner as Example 1, except that 261 parts by weight of NC3000P (produced by Nippon Kayaku Co., Ltd.; a softening point of 57°C; an ICI viscosity at 150°C of 1.11 dPa·s) was used as the epoxy resin contained in the bonding layer.

In this regard, it is to be noted that a melt viscosity at 60°C of a resin varnish for obtaining the bonding layer was 2×10² Pa·s.

Here, on the film for semiconductor, the 180° peel strength (adhesive strength) between the bonding layer and the first adhesive layer thereof was measured in the same manner as Example 1.
As a result of this measurement, the peel strength at 23°c (F₂₃) thereof was 40 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 90 cN/25mm and the peel strength at 60°C (F₆₀) thereof was 257 cN/25mm.
Further, a ratio of F₆₀ to F₂₃ (that is, F₆₀/F₂₃) was 6.4.

Thereafter, 100 chips were continuously picked up at each of the die mount temperatures of 23°C and 130 °C using the die bonder in order to be mounted onto the above bismaleimide triazine resin substrate coated with the solder resist (product name: "AUS308" produced by Taiyo Ink Mfg. Co., Ltd.) and having the circuit step of 5 to 10 µm ("AD898" produced by ASM corporation). In this way, it was judged that the pickup property of the semiconductor element was good or bad.

As a result, all 100 semiconductor elements could be appropriately picked up at the die mount temperature of 23°C. On the other hand, pickup defects occurred at the die mount temperature of 130°C in all 100 semiconductor elements.

### (Comparative Example 3)

Semiconductor devices were manufactured in the same manner as Example 1, except that 261 parts by weight of YSLV80XY (produced by Tohto Kasei Co., Ltd.; a softening point of 80°C; an ICI viscosity at 150°C of 0.03 dPa·s) was used as the epoxy resin contained in the bonding layer.

Here, on the film for semiconductor, the 180° peel strength (adhesive strength) between the bonding layer and the first adhesive layer thereof was measured in the same manner as Example 1.
As a result of this measurement, the peel strength at 23°C (F₂₃) thereof was 104 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 103 cN/25mm and the peel strength at 60°C (F₆₀) thereof was 101 cN/25mm.
Further, a ratio of F₆₀ to F₂₃ (that is, F₆₀/F₂₃) was 0.97.

Thereafter, 100 chips were continuously picked up at each of the die mount temperatures of 23°C and 130°C using the die bonder in order to be mounted onto the above bismaleimide triazine resin substrate coated with the solder resist (product name: "AUS308" produced by Taiyo Ink Mfg. Co., Ltd.) and having the circuit step of 5 to 10 µm ("AD898" produced by ASM corporation). In this way, it was judged that the pickup property of the semiconductor element was good or bad.

As a result, pickup defects occurred at the die mount temperature of 23°C in 60 semiconductor elements. On the other hand, pickup defects also occurred at the die mount temperature of 130°C in 60 semiconductor elements.

### (Comparative Example 4)

Semiconductor devices were manufactured in the same manner as Example 1, except that 261 parts by weight of YX4000K (produced by Japan Epoxy Resin Corporation; a softening point of 110°C; an ICI viscosity at 150°C of 0.13 dPa·s) was used as the epoxy resin contained in the bonding layer.

Here, on the film for semiconductor, the 180° peel strength (adhesive strength) between the bonding layer and the first adhesive layer thereof was measured in the same manner as Example 1.
As a result of this measurement, the peel strength at 23°C (F₂₃) thereof was 97 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 96 cN/25mm and the peel strength at 60°C (F₆₀) thereof was 91 cN/25mm.
Further, a ratio of F₆₀ to F₂₃ (that is, F6₀/F₂₃) was 0.94.

Thereafter, 100 chips were continuously picked up at each of the die mount temperatures of 23°C and 130°C using the die bonder in order to be mounted onto the above bismaleimide triazine resin substrate coated with the solder resist (product name: "AUS308" produced by Taiyo Ink Mfg. Co., Ltd.) and having the circuit step of 5 to 10 µm ("AD898" produced by ASM corporation). In this way, it was judged that the pickup property of the semiconductor element was good or bad.

As a result, pickup defects occurred at the die mount temperature of 23°C in 50 semiconductor elements. On the other hand, pickup defects also occurred at the die mount temperature of 130°C in 50 semiconductor elements.

### (Comparative Example 5)

Semiconductor devices were manufactured in the same manner as Example 1, except that 261 parts by weight of NC6000 (produced by Nippon Kayaku Co., Ltd.; a softening point of 60°C; an ICI viscosity at 150°C of 0.11 dPa·s) was used as the epoxy resin contained in the bonding layer.

Here, on the film for semiconductor, the 180° peel strength (adhesive strength) between the bonding layer and the first adhesive layer thereof was measured in the same manner as Example 1.
As a result, of this measurement, the peel strength at 23°C (F₂₃) thereof was 90 cN/25mm.

Next, the temperature of the film for semiconductor was sequentially risen at 40°C and 60°C. Then, in each temperature, the peel strength thereof was measured in the same manner as the case of 23°C.

As a result of this measurement, the peel strength at 40°C (F₄₀) thereof was 143 cN/25mm and the peel strength at 60°C (F₆₀) thereof was 260 cN/25mm.
Further, a ratio of F₆₀ to F₂₃ (that is, F₆₀/F₂₃) was 2.9.

Thereafter, 100 chips were continuously picked up at each of the die mount temperatures of 23°C and 130°C using the die bonder in order to be mounted onto the above bismaleimide triazine resin substrate coated with the solder resist (product name: "AUS308" produced by Taiyo Ink Mfg. Co., Ltd.) and having the circuit step of 5 to 10 µm ("AD898" produced by ASM corporation). In this way, it was judged that the pickup property of the semiconductor element was good or bad.

As a result, pickup defects occurred at the die mount temperature of 23°C in 50 semiconductor elements. On the other hand, pickup defects also occurred at the die mount temperature of 130°C in all 100 semiconductor elements.

### 2. Evaluation of Dicing Property and Pickup property

The conditions for forming the bonding layer in each of Examples and Comparative Examples and the results of the pickup property are shown in Table 1.

{Table 1}

**Table 1**

| | Constitution of Bonding Layer | | | | | | | | Evaluation Result | | | | |
|---|---|---|---|---|---|---|---|---|---|---|---|---|---|
| | Acrylate Copolymer | Epoxy Resin | | | Phenol Rosin | Coupling Agent | Accelerator | Filler | Peel Strength | | | Pickup Property (Pickup Defect Number) | |
| | Parts by Weight | Softening point [°C] | ICI Viscosity (150°C) [dPa·s] | Parts by Weight (Ratio in Epoxy Resin) | Parts by weight | Parts by Weight | Parts by Weight | Parts by Weight | F₂₃ [cN/ 25mm] | F₆₀ (cN/ 25mm] | F₂₃ | 23 °C | 130 °C |
| Ex. 1 | 100 | 80 | 5.2 | (100%) | 261. 137 | 0.5 | 0.8 | 56 | 25 | 60 | 2.4 | 0 | 0 |
| Ex. 2 | 100 | 57 | 1.11 | 78 (30%) | 137 | 0.5 | 0.8 | 56 | 25 | 83 | 3.3 | 0 | 1 |
| | | 80 | 5.2 | 183 (70%) | | | | | | | | | |
| Ex. 3 | 100 | 85 | 12.0 | 261 (100%) | 137 | 0.5 | 0.8 | 56 | 32 | 37 | 1.2 | 0 | 0 |
| Ex. 4 | 100 | 80 | 10.0 | 261 (100%) | 137 | 0.5 | 0.8 | 56 | 35 | 60 | 2.1 | 0 | 0 |
| Ex. 5 | 100 | 90 | 4.5 | 261 (100%) | 137 | 0.5 | 0.8 | 56 | 50 | 80 | 1.6 | 0 | 0 |
| Comp. Ex. 1 | 100 | 45 | 0.03 | 261 (100%) | 137 | 0.5 | 0.8 | 56 | 112 | 300 | 2.7 | 60 | 100 |
| Comp. Ex. 2 | 100 | 57 | 1.11 | 261 (100%) | 137 | 0.5 | 0.8 | 56 | 40 | 257 | 6.4 | 0 | 100 |
| Comp. Ex. 3 | 100 | 80 | 0.03 | 261 | 137 | 0.5 | 0.8 | 56 | 104 | 101 | 0.97 | 60 | 60 |
| Comp. Ex. 4 | 100 | 110 | 0.13 | 261 (100%) | 137 | 0.5 | 0.8 | 56 | 97 | 91 | 0.94 | 50 | 50 |
| Comp. Ex. 5 | 100 | 60 | 0.11 | 261 (100%) | 137 | 0.5 | 0.8 | 56 | 90 | 260 | 2.9 | 50 | 100 |

As evidenced by Table 1, the film for semiconductor obtained in each of Examples and Comparative Examples exhibits an excellent dicing property. Namely, crack, peel off or the like is not generated in the semiconductor element obtained in each of Examples and Comparative Examples during the dicing step.

Further, it becomes apparent that it is possible to stably carry out the pickup of the semiconductor element (chip) in each of Examples. Especially, it is possible to stably carry out the pickup of the semiconductor element regardless of the die mount temperature (23°C or 130°C) when being picked up. For the reason, according to each of Examples, even in the case where the collet of the die bonder becomes hot so that the temperature of the laminated body rises during the pickup step, it becomes apparent that it is possible to reliably prevent the pickup defects of the semiconductor element from occurring.
On the other hand, in each of Comparative Examples, pickup defects occur in relatively many semiconductor elements regardless of the above temperature.

Furthermore, in Comparative Example 2, the pickup of the semiconductor element is appropriately carried out at the die mount temperature of 23°C, but the pickup defects occur at the die mount temperature of 130°C. This result indicates that in the case of Comparative Examples, pickup defects may occur in many semiconductor elements when the collet of the die bonder becomes hot.

### INDUSTRIAL APPLICABILITY

A film for semiconductor of the present invention comprises a bonding layer, at least one adhesive layer and a support film which are laminated together in this order. The film for semiconductor is adapted to be used for picking up chips obtained by laminating a semiconductor wafer onto an opposite surface of the bonding layer to the adhesive layer, and then dicing the semiconductor wafer together with the bonding layer in the laminated state into the chips. In the case where adhesive strength measured when the chip is peeled off from the adhesive layer at 23°C is defined as "F₂₃ (cN/25mm)" and adhesive strength measured when the chip is peeled off from the adhesive layer at 60°C is defined as "F₆₀ (cN/25mm)", F₂₃ is in the range of 10 to 80 and F₆₀/F₂₃ is in the range of 0.3 to 5.5.
In this case, the film for semiconductor is configured so that a ratio of peel strength at a high temperature (60°C) between the adhesive layer and the bonding layer to peel strength at a low temperature (23°C) between the adhesive layer and the bonding layer becomes a predetermined value. Therefore, even in the case where heat is transferred to the chip when being picked up, it is possible to prevent a pickup property of the chip from being lowered. Therefore, according to the present invention, it is possible to obtain a film for semiconductor which can improve a yield ratio of manufacturing semiconductor devices and to manufacture semiconductor devices each having high reliability. Therefore, the film for semiconductor of the present invention provides industrial applicability.

## Claims

1. A film for semiconductor comprising a bonding layer, at least one adhesive layer and a support film which are laminated together in this order, the film for semiconductor being adapted to be used for picking up chips obtained by laminating a semiconductor wafer onto a surface of the bonding layer opposite to the adhesive layer, and then dicing the semiconductor wafer together with the bonding layer in the laminated state into the chips,
wherein in the case where adhesive strength measured when the chip is peeled off from the adhesive layer at 23°C is defined as "F₂₃ (cN/25mm)" and adhesive strength measured when the chip is peeled off from the adhesive layer at 60°C is defined as "F₆₀ (cN/25mm)", F₂₃ is in the range of 10 to 80 and F₆₀/F₂₃ is in the range of 0.3 to 5.5.

2. The film for semiconductor as claimed in claim 1, wherein a constituent material of the bonding layer contains a thermosetting resin including a compound having a softening point of 70 to 130°C of which amount is in the range of 60 to 100 wt%.

3. The film for semiconductor as claimed in claim 1, wherein a constituent material of the bonding layer contains a thermosetting resin including a compound having a softening point of 30°C or more but less than 70°C of which amount is in the range of 30 wt% or less.

4. The film for semiconductor as claimed in claim 1, wherein a constituent material of the bonding layer contains a thermosetting resin including a compound having an ICI viscosity at 25°C of 1 to 20 dPa·s of which amount is in the range of 60 to 100 wt%.

5. The film for semiconductor as claimed in claim 1, wherein a melt viscosity at 60°C of a constituent material of the bonding layer is in the range of 1 × 10² to 1 × 10⁵ Pa·s.

6. The film for semiconductor as claimed in claim 1, wherein a constituent material of the bonding layer contains an acryl-based resin and an epoxy-based resin.

7. The film for semiconductor as claimed in claim 1, wherein a constituent material of the bonding layer contains a phenol-based resin.

8. The film for semiconductor as claimed in claim 1, wherein the at least one adhesive layer comprises a plurality of adhesive layers.

9. The film for semiconductor as claimed in claim 1, wherein the plurality of adhesive layers includes a first adhesive layer positioned at a side of the semiconductor wafer, and a second adhesive layer provided between the first adhesive layer and the support film, the second adhesive layer having an adhesive property larger than that of the first adhesive layer.

10. The film for semiconductor as claimed in claim 9, wherein a peripheral edge of the bonding layer and a peripheral edge of the first adhesive layer are located inside a peripheral edge of the second adhesive layer, respectively.

11. The film for semiconductor as claimed in claim 9, wherein hardness of the second adhesive layer is smaller than that of the first adhesive layer.

12. The film for semiconductor as claimed in claim 9, wherein Shore D hardness of the first adhesive layer is in the range of 20 to 60.

13. The film for semiconductor as claimed in claim 1, wherein a region of a surface of the adhesive layer facing the bonding layer, above which the semiconductor wafer is to be laminated, has been, in advance, irradiated with an ultraviolet ray before the semiconductor wafer is laminated onto the film for semiconductor.

14. A method for manufacturing a semiconductor device comprising:
a first step of laminating a semiconductor wafer onto the film for semiconductor defined by claim 1 so that the semiconductor wafer makes contact with the bonding layer to obtain a laminated body;
a second step of dicing the semiconductor wafer into a plurality of semiconductor elements by forming cutting lines into the laminated body from a side of the semiconductor wafer; and
a third step of picking up the chips each comprising the semiconductor element with the diced bonding layer.

15. The method for manufacturing a semiconductor device as claimed in claim 14, wherein the cutting lines are formed so that deepest points thereof are located within the adhesive layer.

16. The method for manufacturing a semiconductor device as claimed in claim 14, wherein a cross sectional area of a distal end portion of each cutting line, which extends beyond an interface between the bonding layer and the adhesive layer, is in the range of 5 × 10⁻⁵ to 300 × 10⁻⁵ mm².
